# EUROPEAN PATENT APPLICATION

(11) **EP 4 615 203 A1**
(43) Date of publication of application: **10.09.2025**
(21) Application number: 25161096.0
(22) Date of filing: 28.02.2025
(51) Int. Cl.: H10K 50/824, H10K 50/844, H10K 59/122, H10K 59/80

(54) **DISPLAY PANEL AND METHOD OF MANUFACTURING THE SAME**

(30) Priority: 04.03.2024 KR 20240030960
(71) Applicant: Samsung Display Co., Ltd., Yongin-si, Gyeonggi-do 17113 (KR)
(72) Inventor: PARK, Heemin, 17113 Yongin-si (KR)
(74) Representative: Marks & Clerk LLP

(57) **Abstract**

A display panel includes: a base layer, a pixel defining film disposed on the base layer and defining a light emitting opening therein, an auxiliary electrode disposed on the pixel defining film and including a conductive material, a light emitting element including an anode, a light emitting pattern disposed on the pixel defining film and the auxiliary electrode, and a cathode disposed on the auxiliary electrode and the light emitting pattern, and a lower encapsulation inorganic pattern that covers the light emitting element.

## Description

### BACKGROUND

Embodiments of the present disclosure relate to a display panel and a method of manufacturing a display panel, and more particularly, a display panel having improved display quality.

Display devices such as televisions, monitors, smart phones, and tablet personal computers ("PCs") that provide images to users include display panels that display images. Various display panels such as liquid crystal display panels, organic light emitting display panels, electro wetting display panels, and electrophoretic display panels have been developed as the display panels.

The organic light emitting display panel may include an anode, a cathode, and a light emitting pattern. The light emitting pattern may be separated for each of light emitting areas, and the cathode may provide a common voltage to each of the light emitting areas.

### SUMMARY

Embodiments of the present disclosure provide a display panel forming a light emitting element without using a metal mask and having improved display quality, and a method of manufacturing the same.

According to an embodiment, a display panel includes a base layer, a pixel defining film disposed on the base layer and defining a light emitting opening therein, an auxiliary electrode disposed on the pixel defining film and including a conductive material, a light emitting element including an anode, a light emitting pattern disposed on the pixel defining film and the auxiliary electrode, and a cathode disposed on the auxiliary electrode and the light emitting pattern, and a lower encapsulation inorganic pattern that covers the light emitting element.

A distal end of the cathode may be in direct contact with an upper surface of the auxiliary electrode.

The cathode may be in direct contact with a side surface of the auxiliary electrode.

The lower encapsulation inorganic pattern may cover the cathode and may be in direct contact with an upper surface of the auxiliary electrode.

The auxiliary electrode may define an auxiliary opening therein, and the auxiliary opening may overlap the light emitting opening in a thickness direction of the base layer.

The light emitting pattern may be disposed inside the light emitting opening and the auxiliary opening.

The auxiliary electrode may include titanium (Ti).

A distal end of the lower encapsulation inorganic pattern may extend in the thickness direction of the base layer.

The light emitting element and the lower encapsulation inorganic pattern may each be provided in plurality, and the plurality of light emitting elements may be spaced apart from each other, and the plurality of lower encapsulation inorganic patterns may be spaced apart from each other while covering the light emitting elements, respectively.

The display panel may further include a common inorganic film having an integral shape while covering the plurality of lower encapsulation inorganic patterns, an encapsulation organic film disposed on the common inorganic film, and an upper encapsulation inorganic film disposed on the encapsulation organic film.

Outer surfaces of the plurality of lower encapsulation inorganic patterns may define a gap area, and the common inorganic film may cover the outer surfaces of the plurality of lower encapsulation inorganic patterns and an upper surface of the auxiliary electrode.

According to an embodiment, a display panel includes a base layer, a pixel defining film disposed on the base layer and defining a first light emitting opening and a second light emitting opening therein, an auxiliary electrode disposed on the pixel defining film, a first light emitting element including a first anode, a first light emitting pattern, and a first cathode that are sequentially arranged in a thickness direction of the base layer, a second light emitting element including a second anode, a second light emitting pattern, and a second cathode that are sequentially arranged in the thickness direction of the base layer, a first (lower) encapsulation inorganic pattern that is disposed on the first light emitting element and the auxiliary electrode and covers the first light emitting element, a second (lower) encapsulation inorganic pattern that is disposed on the second light emitting element and the auxiliary electrode, covers the second light emitting element, and is spaced apart from the first (lower) encapsulation inorganic pattern, and a common inorganic film that covers an upper surface and an outer surface of the first (lower) encapsulation inorganic pattern, an upper surface and an outer surface of the second (lower) encapsulation inorganic pattern, and an upper surface of the auxiliary electrode.

According to an embodiment, a method of manufacturing a display panel includes: providing a preliminary display panel including a base layer and a pixel defining film disposed on the base layer; forming a preliminary partition wall including a first preliminary partition wall layer, a second preliminary partition wall layer, and a third preliminary partition wall layer and disposed on the preliminary display panel; forming a partition wall defining a plurality of partition wall openings therein and including a first partition wall layer, a second partition wall layer, and a third partition wall layer from the preliminary partition wall; forming a plurality of light emitting openings overlapping the plurality of partition wall openings by etching the pixel defining film; forming a plurality of light emitting elements disposed on the pixel defining film and the first partition wall layer; forming a plurality of lower encapsulation inorganic patterns covering the plurality of light emitting elements and disposed on the light emitting element and the first partition wall layer, and forming an auxiliary electrode by removing the second preliminary partition wall layer and the third preliminary partition wall layer.

The forming of the partition wall may include dry etching the first to third preliminary partition wall layers, and wet etching the second preliminary partition wall layer, where the second partition wall layer may be recessed inward as compared to the first and third partition wall layers.

The forming of the plurality of light emitting elements may include forming a light emitting pattern disposed on the pixel defining film and the first partition wall layer, and forming a cathode disposed on the light emitting pattern such that a distal end of the cathode is in contact with an upper surface of the first partition wall layer.

The forming of the plurality of lower encapsulation inorganic patterns may include depositing a lower encapsulation inorganic layer such that the lower encapsulation inorganic layer covers the cathode and is in direct contact with the upper surface of the first partition wall layer.

The forming of the plurality of lower encapsulation inorganic patterns may include depositing a lower encapsulation inorganic layer such that the lower encapsulation inorganic layer is in contact with the upper surface of the first partition wall layer and a side surface of the second partition wall layer.

The forming of the auxiliary electrode may include forming a gap area between outer surfaces of the plurality of lower encapsulation inorganic patterns.

The method may further include forming a common inorganic film having an integral shape and covering the outer surfaces of the plurality of lower encapsulation inorganic patterns.

The method may further include forming a common inorganic film in contact with an upper surface of the auxiliary electrode and covering the plurality of lower encapsulation inorganic patterns.

The forming of the preliminary partition wall may include depositing the first preliminary partition wall layer, which contains titanium (Ti), depositing the second preliminary partition wall layer, which contains aluminium (Al), and depositing the third preliminary partition wall layer, which contains titanium (Ti).

At least some of the above and other features of the invention are set out in the claims.

### BRIEF DESCRIPTION OF THE FIGURES

The above and other aspects and features of the present disclosure will become apparent by describing in detail embodiments thereof with reference to the accompanying drawings.
FIG. 1A is a perspective view of a display device according to an embodiment of the present disclosure.
FIG. 1B is an exploded perspective view of the display device according to an embodiment of the present disclosure.
FIG. 2 is a cross-sectional view of a display module according to an embodiment of the present disclosure.
FIG. 3 is a plan view of a display panel according to an embodiment of the present disclosure.
FIG. 4 is an enlarged plan view of a portion of a display area of the display panel according to an embodiment of the present disclosure.
FIG. 5 is a cross-sectional view of the display panel along line I-I' of FIG. 3.
FIG. 6 is a cross-sectional view of the display panel along line II-II' of FIG. 4.
FIGS. 7A to 7L are cross-sectional views illustrating some of the operations of a method of manufacturing the display panel according to an embodiment of the present disclosure.

### DETAILED DESCRIPTION

In the specification, the expression that a first component (or area, layer, part, portion, etc.) is "disposed on", "connected with" or "coupled to" a second component means that the first component is directly disposed on/connected with/coupled to the second component or means that a third component is interposed therebetween.

The same reference numerals refer to the same components. Further, in the drawings, the thickness, the ratio, and the dimension of components are exaggerated for effective description of technical contents. The expression "and/or" includes one or more combinations which associated components are capable of defining.

Although the terms "first", "second", etc. may be used to describe various components, the components should not be limited by the terms. The terms are only used to distinguish one component from another component. For example, without departing from the right scope of the present disclosure, a first component may be referred to as a second component, and similarly, the second component may be also referred to as the first component. Singular expressions include plural expressions unless clearly otherwise indicated in the context.

Also, the terms "under", "below", "on", "above", etc. are used to describe the correlation of components illustrated in drawings. The terms that are relative in concept are described based on a direction illustrated in drawings.

It will be understood that the terms "include", "comprise", "have", etc. specify the presence of features, numbers, steps, operations, elements, or components, described in the specification, or a combination thereof, and do not exclude in advance the presence or additional possibility of one or more other features, numbers, steps, operations, elements, or components or a combination thereof.

Unless otherwise defined, all terms (including technical terms and scientific terms) used in the specification have the same meaning as commonly understood by those skilled in the art to which the present disclosure belongs. Further, terms such as terms defined in the dictionaries commonly used should be interpreted as having a meaning consistent with the meaning in the context of the related technology and should not be interpreted in overly ideal or overly formal meanings unless explicitly defined herein.

Hereinafter, an embodiment of the present disclosure will be described with reference to the accompanying drawings.

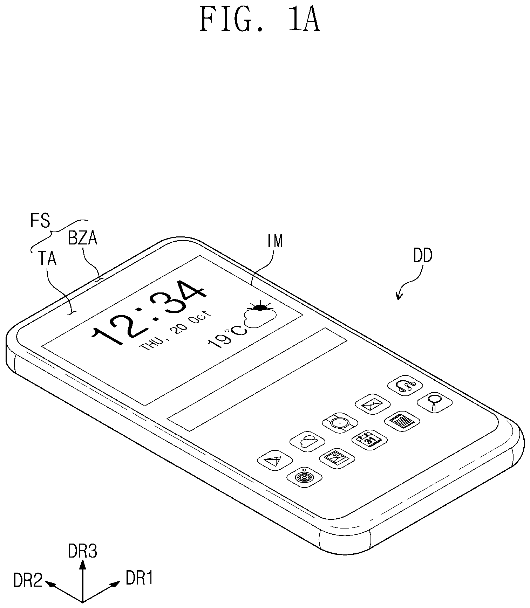

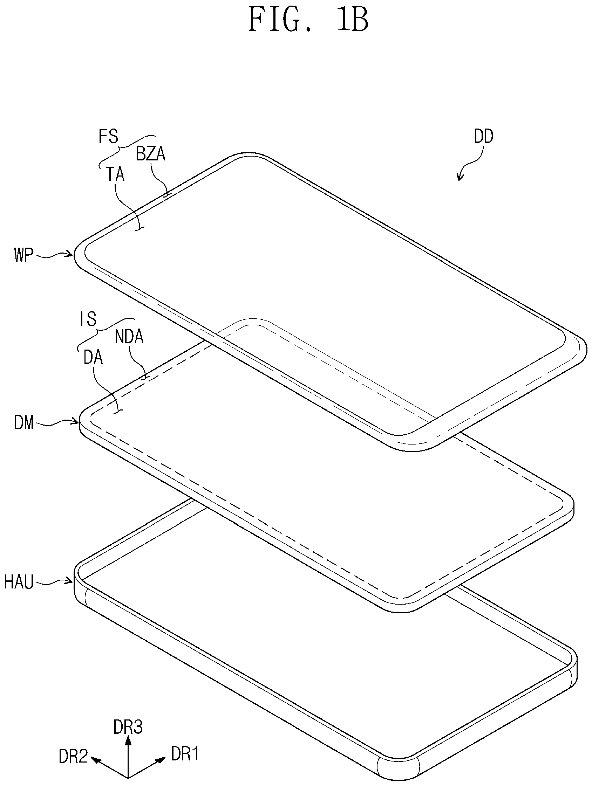

FIG. 1A is a perspective view of a display device DD according to an embodiment of the present disclosure, and FIG. 1B is an exploded perspective view of the display device DD according to an embodiment of the present disclosure.

In an embodiment, the display device DD may be a large electronic device such as a television, a monitor, or an external billboard. Further, the display device DD may be a small or medium-sized electronic device such as a personal computer (PC), a laptop, a personal digital terminal, a vehicle navigation unit, a game console, a smart phone, a tablet PC, and a camera. However, this is illustrative, and other display devices may be adopted as long as the display devices do not deviate from the concept of the present disclosure. It is illustratively illustrated in FIGS. 1A and 1B that the display device DD is a smart phone.

Referring to FIGS. 1A and 1B, the display device DD may display an image IM in a third direction DR3 on a display surface FS parallel to a first direction DR1 and a second direction DR2. The image IM may include a still image as well as a dynamic image. In FIG. 1A, a watch window and icons are illustrated as an example of the image IM. The display surface FS on which the image IM is displayed may correspond to a front surface of the display device DD.

In an embodiment, a front surface (or an upper surface) and a rear surface (or a lower surface) of each member are defined with respect to a direction, in which the image IM is displayed. The front surface and the rear surface may face each other in the third direction DR3, and a normal direction of each of the front and rear surfaces may be parallel to the third direction DR3. Meanwhile, directions indicated by the first to third directions DR1, DR2, and DR3 are relative concepts and may be changed to other directions. In the specification, a phrase of "on a plane" may mean a state when viewed in the third direction DR3 (i.e., in a plan view).

The display device DD may include a window WP, a display module DM, and a housing HAU. The window WP and the housing HAU may be coupled to each other to constitute an exterior of the display device DD.

The window WP may include an optically transparent insulating material. For example, the window WP may include a glass or plastic. A front surface of the window WP may define the display surface FS of the display device DD. The display surface FS may include a transmissive area TA and a bezel area BZA. The transmissive area TA may be an optically transparent area. For example, the transmissive area TA may be an area having a visible light transmittance of about 90% or more.

The bezel area BZA may be an area having a relatively lower light transmittance than a light transmittance of the transmissive area TA. The bezel area BZA may define a shape of the transmissive area TA. The bezel area BZA may be adjacent to the transmissive area TA and surround the transmissive area TA. However, this is illustrative, and the bezel area BZA of the window WP may be omitted. The window WP may include at least one functional layer of a fingerprint preventing layer, a hard coating layer, and a reflection preventing layer, and is not limited to an embodiment.

The display module DM may be disposed under the window WP. The display module DM may be a component that substantially generates the image IM. The image IM generated by the display module DM is displayed on a display surface IS of the display module DM and is visually recognized by a user from the outside through the transmissive area TA.

The display module DM may include a display area DA and a non-display area NDA. The display area DA may be an area that is activated according to an electric signal. The non-display area NDA may be adjacent to the display area DA. The non-display area NDA may surround the display area DA. The non-display area NDA is an area covered by the bezel area BZA and may not be visually recognized from the outside.

The housing HAU may be coupled to the window WP. The housing HAU may be coupled to the window WP to provide a predetermined inner space. The display module DM may be accommodated in the inner space.

The housing HAU may include a material having a relatively high rigidity. For example, the housing HAU may include a plurality of frames and/or plates including a glass, a plastic, or a metal or made of a combination thereof. The housing HAU may stably protect components of the display device DD accommodated in the inner space from an external impact.

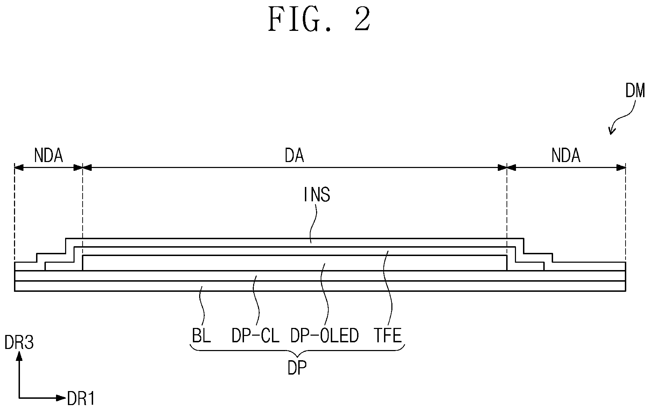

FIG. 2 is a cross-sectional view of the display module DM according to an embodiment of the present disclosure.

Referring to FIG. 2, the display module DM may include a display panel DP and an input sensor INS. Although not separately illustrated, the display device DD (see FIG. 1A) according to an embodiment of the present disclosure may further include a protective member disposed on a lower surface of the display panel DP or a reflection preventing member and/or a window member disposed on an upper surface of the input sensor INS.

The display panel DP may be a light emitting display panel. However, this is illustrative, and the present disclosure is not particularly limited thereto. For example, the display panel DP may be an organic light emitting display panel or an inorganic light emitting display panel. A light emitting layer in the organic light emitting display panel may include an organic light emitting material. A light emitting layer in the inorganic light emitting display panel may include a quantum dot, a quantum rod, or a micro light emitting diode ("LED"). Hereinafter, the display panel DP will be described as the organic light emitting display panel.

The display panel DP may include a base layer BL, and a circuit element layer DP-CL, a display element layer DP-OLED, and a thin film encapsulation layer TFE which are arranged on the base layer BL. The input sensor INS may be directly disposed on the thin film encapsulation layer TFE. In the specification, the wording "component A is directly disposed on component B" means that no adhesive layer is disposed between component A and component B.

The base layer BL may include at least one plastic film. The base layer BL is a flexible substrate and may include a plastic substrate, a glass substrate, a metal substrate, or an organic/inorganic composite material substrate. The display area DA and the non-display area NDA described in FIG. 1B may be equally defined on the base layer BL.

The circuit element layer DP-CL may include at least one insulating layer and a circuit element. The insulating layer includes at least one inorganic layer and at least one organic layer. The circuit element includes signal lines, a driving circuit of a pixel, and the like.

The display element layer DP-OLED may include a partition wall and a light emitting element. The light emitting element may include an anode, an intermediate layer, and a cathode.

The thin film encapsulation layer TFE may include a plurality of thin films. Some thin films may be arranged to improve optical efficiency, and some thin films may be arranged to protect organic light emitting diodes.

The input sensor INS acquires coordinate information of an external input. The input sensor INS may have a multilayer structure. The input sensor INS may include a single-layered or multi-layered conductive layer. Further, the input sensor INS may include a single-layered or multi-layered insulating layer. The input sensor INS may sense the external input in a capacitive manner. However, this is illustrative, and the present disclosure is not limited thereto. For another example, in an embodiment, the input sensor INS may sense the external input in an electromagnetic induction manner or a pressure sensing manner. In another embodiment of the present disclosure, the input sensor INS may be omitted.

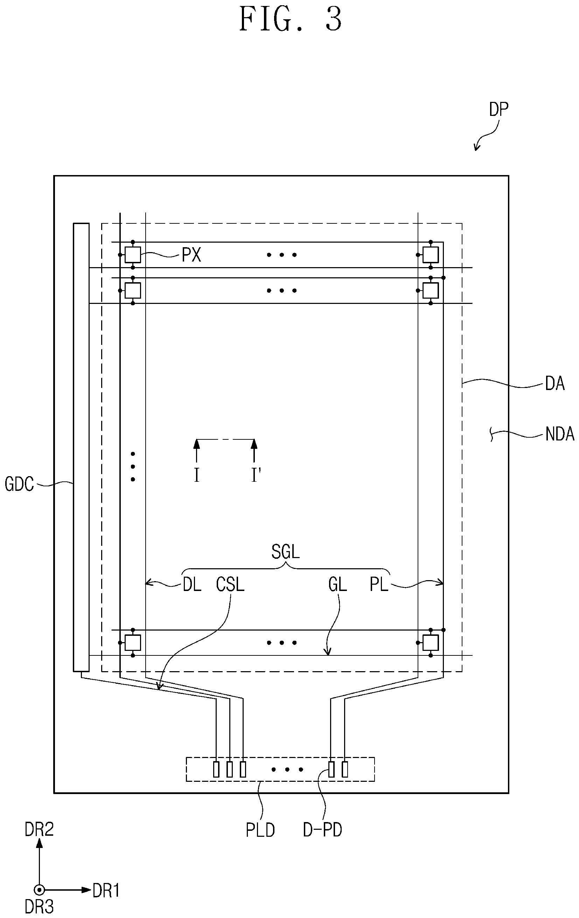

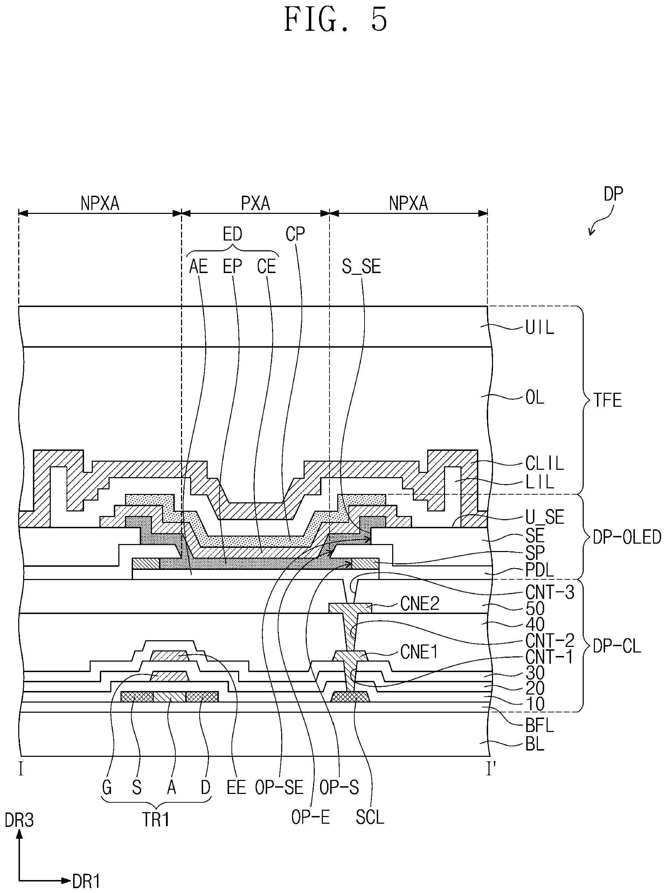

FIG. 3 is a plan view of a display panel DP according to an embodiment of the present disclosure. As used herein, the "plan view" is a view in a thickness direction (i.e., a third direction DR3) of the base layer BL (See FIG. 5).

Referring to FIG. 3, the display area DA and the non-display area NDA around the display area DA may be defined by the display panel DP. The display panel DP may include pixels PX and signal lines SGL electrically connected to the pixels PX. The display panel DP may further include a driving circuit GDC and a pad part PLD. The display area DA and the non-display area NDA may be distinguished from each other depending on whether the pixel PX is disposed. The pixel PX may be disposed in the display area DA. The driving circuit GDC and the pad part PLD may be arranged in the non-display area NDA.

The pixels PX may be arranged in the first direction DR1 and the second direction DR2. The pixels PX may include a plurality of pixel rows extending in the first direction DR1 and arranged in the second direction DR2 and a plurality of pixel columns extending in the second direction DR2 and arranged in the first direction DR1.

The signal lines SGL may include gate lines GL, data lines DL, a power line PL, and a control signal line CSL. Each of the gate lines GL may be connected to a corresponding pixel PX among the pixels PX, and each of the data lines DL may be connected to a corresponding pixel among the pixels PX. The power line PL may be electrically connected to the pixels PX. The control signal line CSL may be connected to the driving circuit GDC to provide control signals to the driving circuit GDC.

The driving circuit GDC may include a gate driving circuit. The gate driving circuit may generate gate signals and sequentially output the generated gate signals to the gate lines GL. The gate driving circuit may further output another control signal to a pixel driving circuit.

The pad part PLD may be a part to which a flexible circuit board is connected. The pad part PLD may include pixel pads D-PD, and the pixel pads D-PD may be pads for connecting the flexible circuit board to the display panel DP. Each of the pixel pads D-PD may be connected to a corresponding signal line SGL among the signal lines SGL. The pixel pads D-PD may be connected to the corresponding pixels PX through the signal lines SGL. Further, any one pixel pad D-PD among the pixel pads D-PD may be connected to the driving circuit GDC.

Further, the pad part PLD may further include input pads. The input pads may be pads for connecting the flexible circuit board to the input sensor INS (see FIG. 2). However, the present disclosure is not limited thereto, and the input pads may be arranged in the input sensor INS (see FIG. 2) and connected to the pixel pads D-PD and a separate circuit board in another embodiment. Alternatively, the input sensor INS (see FIG. 2) may be omitted and may not further include the input pads.

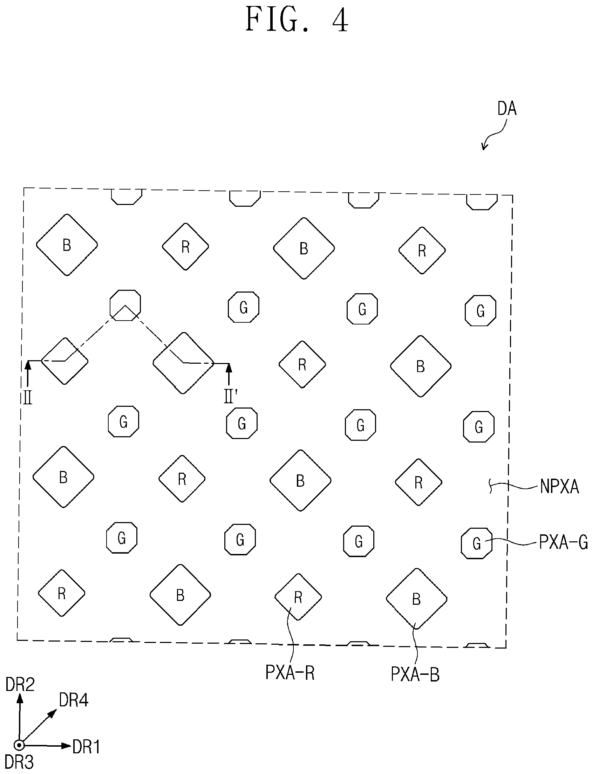

FIG. 4 is an enlarged plan view of a portion of the display area DA of the display panel DP (see FIG. 2) according to an embodiment of the present disclosure. FIG. 4 is a plan view of the display module DM when viewed from the display surface IS (see FIG. 1B) of the display module DM (see FIG. 1B) and illustrates an arrangement of light emitting areas PXA-R, PXA-G, and PXA-B.

Referring to FIG. 4, the display area DA may include the first to third light emitting areas PXA-R, PXA-G, and PXA-B and a peripheral area NPXA surrounding the first to third light emitting areas PXA-R, PXA-G, and PXA-B. The first to third light emitting areas PXA-R, PXA-G, and PXA-B may respectively correspond to areas from which lights provided from the light emitting elements are emitted. The first to third light emitting areas PXA-R, PXA-G, and PXA-B may be distinguished according to a color of the light emitted toward the outside of the display module DM (see FIG. 2).

The first to third light emitting areas PXA-R, PXA-G, and PXA-B may provide first to third color lights having different colors, respectively. For example, the first color light may be a red light, the second color light may be a green light, and the third color light may be a blue light. However, an example of the first to third color lights is not necessarily limited to the above example.

Each of the first to third light emitting areas PXA-R, PXA-G, and PXA-B may be defined as an area in which an upper surface of the anode is exposed by a light emitting opening OP-E (See FIG. 5), which will be described below. The peripheral area NPXA may set boundaries between the first to third light emitting areas PXA-R, PXA-G, and PXA-B and prevent color mixing between the first to third light emitting areas PXA-R, PXA-G, and PXA-B.

The first to third light emitting areas PXA-R, PXA-G, and PXA-B may be provided such that all of the numbers thereof are plural and may be repeatedly arranged in the display area DA in a specific arrangement form. For example, the first and third light emitting areas PXA-R and PXA-B may be alternately arranged in the first direction DR1 to constitute a "first group." The second light emitting areas PXA-G may arranged in the first direction DR1 to constitute a "second group." Each of the "first group" and the "second group" may be provided in plurality, and the "first groups" and the "second groups" may be alternately arranged in the second direction DR2.

One second light emitting area PXA-G may be spaced apart from one first light emitting area PXA-R or one third light emitting area PXA-B in a fourth direction DR4. The fourth direction DR4 may be defined as a direction between the first and second directions DR1 and DR2.

FIG. 4 illustratively illustrates an arrangement form of the first to third light emitting areas PXA-R, PXA-G, and PXA-B, but the present disclosure is not limited thereto, and the first to third light emitting areas PXA-R, PXA-G, and PXA-B may be arranged in various forms. In an embodiment, as illustrated in FIG. 4, the first to third light emitting areas PXA-R, PXA-G, and PXA-B may have a PENTILE^{™} arrangement form. Alternatively, the first to third light emitting areas PXA-R, PXA-G, and PXA-B may also have a stripe arrangement form or a diamond pixel^{™} arrangement form.

The first to third light emitting areas PXA-R, PXA-G, and PXA-B may have various shapes on a plane. For example, the first to third light emitting areas PXA-R, PXA-G, and PXA-B may have shapes such as a polygonal shape, a circular shape, or an elliptic shape. FIG. 4 illustratively illustrates the first and third light emitting areas PXA-R and PXA-B having a quadrangular shape (or a diamond shape) and the second light emitting area PXA-G having an octagonal shape on a plane.

The first to third light emitting areas PXA-R, PXA-G, and PXA-B may have the same shape on a plane or may have at least partially different shapes. FIG. 4 illustratively illustrates the first and third light emitting areas PXA-R and PXA-B having the same shape and the second light emitting area PXA-G having a shape different from shapes of the first and third light emitting areas PXA-R and PXA-B on a plane (i.e., in a plan view).

At least some of the first to third light emitting areas PXA-R, PXA-G, and PXA-B may have different areas on a plane. In an embodiment, an area of the first light emitting area PXA-R that emits a red light may be greater than an area of the second light emitting area PXA-G that emits a green light and may be smaller than an area of the third light emitting area PXA-B that emits a blue light. However, a size relationship between the areas of the first to third light emitting areas PXA-R, PXA-G, and PXA-B according to the color of the emitted light is not limited thereto and may be changed depending on a design of the display module DM (see FIG. 2). Further, the present disclosure is not limited thereto, and the first to third light emitting areas PXA-R, PXA-G, and PXA-B may also have the same area on a plane in another embodiment.

Meanwhile, the shape, the area, the arrangement, and the like of the first to third light emitting areas PXA-R, PXA-G, and PXA-B of the display module DM (see FIG. 2) of the present disclosure may be variously designed according to the color of the emitted light or the size and configuration of the display module DM (see

FIG. 2) and are not limited to an embodiment illustrated in FIG. 4.

FIG. 5 is a cross-sectional view of the display panel DP along line I-I' of FIG. 3. In description of FIG. 5, the description will be made with reference to FIG. 2, and descriptions for the same reference numerals will be omitted. FIG. 5 enlargedly illustrates one light emitting area PXA in the display area DA (see FIG. 4), and the light emitting area PXA of FIG. 5 may correspond to one of the first to third light emitting areas PXA-R, PXA-G, and PXA-B of FIG. 4.

Referring to FIG. 5, the display panel DP may include the base layer BL, the circuit element layer DP-CL, the display element layer DP-OLED, and the thin film encapsulation layer TFE.

The display panel DP may include a plurality of insulating layers, a plurality of semiconductor patterns, a plurality of conductive patterns, a plurality of signal lines, and the like. The insulating layer, the semiconductor layer, and the conductive layer are formed by coating, deposition, or the like. Thereafter, the insulating layer, the semiconductor layer, and the conductive layer may be selectively patterned by photolithography and etching. In this manner, the semiconductor pattern, the conductive pattern, the signal line, and the like included in the circuit element layer DP-CL and the display element layer DP-OLED may be formed.

The circuit element layer DP-CL may be disposed on the base layer BL. The circuit element layer DP-CL may include a buffer layer BFL, a transistor TR1, a signal transmitting area SCL, first to fifth insulating layers 10, 20, 30, 40, and 50, an electrode EE, and a plurality of connection electrodes CNE1 and CNE2.

The buffer layer BFL may be disposed on the base layer BL. The buffer layer BFL may improve a coupling force between the base layer BL and the semiconductor pattern. The buffer layer BFL may include a silicon oxide layer and a silicon nitride layer. The silicon oxide layer and the silicon nitride layer may be alternately laminated.

The semiconductor pattern may be disposed on the buffer layer BFL. The semiconductor pattern may include polysilicon. However, the present disclosure is not limited thereto, and the semiconductor pattern may include an amorphous silicon or a metal oxide in another embodiment. FIG. 5 merely illustratively illustrates a portion of the semiconductor pattern, and the semiconductor patterns may be further arranged in the plurality of light emitting areas PXA-R, PXA-G, and PXA-B (see FIG. 4). The semiconductor pattern may be arranged in a specific rule across the plurality of light emitting areas PXA-R, PXA-G, and PXA-B. The semiconductor pattern may have a different electrical property depending on whether or not the semiconductor pattern is doped. The semiconductor pattern may include a first area having a high doping concentration and a second area having a low doping concentration. The first area may be doped with an N-type dopant or a P-type dopant. A P-type transistor may include the first area doped with the P-type dopant.

A conductivity of the first area is greater than a conductivity of the second area, and the first area may substantially serve as an electrode or a signal line. The second area may substantially correspond to an active area (or a channel) of a transistor. In other words, a portion of the semiconductor pattern may be the active area of the transistor, another portion of the semiconductor pattern may be a source area or a drain area of the transistor, and still another portion of the semiconductor pattern may be a conductive area.

A source area S, an active area A, and a drain area D of the transistor TR1 may be formed from the semiconductor pattern. FIG. 5 illustrates a portion of the signal transmitting area SCL formed from the semiconductor pattern. Although not separately illustrated, the signal transmitting area SCL may be connected to the drain area D of the transistor TR1 on a plane.

The first to fifth insulating layers 10, 20, 30, 40, and 50 may be arranged on the buffer layer BFL. The first to fifth insulating layers 10, 20, 30, 40, and 50 may be inorganic layers or organic layers.

The first insulating layer 10 may be disposed on the buffer layer BFL. The first insulating layer 10 may cover the source area S, the active area A, and the drain area D of the transistor TR1 disposed on the buffer layer BFL, and the signal transmitting area SCL. A gate "G" of the transistor TR1 may be disposed on the first insulating layer 10. The second insulating layer 20 may be disposed on the first insulating layer 10 to cover the gate G. The electrode EE may be disposed on the second insulating layer 20. The third insulating layer 30 may be disposed on the second insulating layer 20 to cover the electrode EE.

The first connection electrode CNE1 may be disposed on the third insulating layer 30. The first connection electrode CNE1 may be connected to the signal transmitting area SCL through a contact hole CNT-1 passing through the first to third insulating layers 10, 20, and 30. The fourth insulating layer 40 may be disposed on the third insulating layer 30 to cover the first connection electrode CNE1. The fourth insulating layer 40 may be an organic layer.

The second connection electrode CNE2 may be disposed on the fourth insulating layer 40. The second connection electrode CNE2 may be connected to the first connection electrode CNE1 through a contact hole CNT-2 passing through the fourth insulating layer 40. The fifth insulating layer 50 may be disposed on the fourth insulating layer 40 to cover the second connection electrode CNE2. The fifth insulating layer 50 may be an organic layer.

The display element layer DP-OLED may be disposed on the circuit element layer DP-CL. The display element layer DP-OLED may include a light emitting element ED, a sacrificial pattern SP, a pixel defining film PDL, a capping pattern CP, and an auxiliary electrode SE.

The light emitting element ED may include an anode AE (or a first electrode), a light emitting pattern EP, and a cathode CE (or a second electrode). The light emitting element ED may be disposed in a light emitting opening OP-E and an auxiliary opening OP-SE, which will be described below.

The anode AE may be disposed on the fifth insulating layer 50 of the circuit element layer DP-CL. The anode AE may be a transmissive electrode, a semi-transmissive electrode, or a reflective electrode. The anode AE may be connected to the second connection electrode CNE2 through a contact hole CNT-3 defined through the fifth insulating layer 50. Thus, the anode AE may be electrically connected to the signal transmitting area SCL through the first and second connection electrodes CNE1 and CNE2 and thus electrically connected to the corresponding circuit element. The anode AE may include a single-layer structure or a multi-layer structure. The anode AE may include a plurality of layers including ITO and Ag. For example, the anode AE may include a layer including the ITO (hereinafter, referred to as a lower ITO layer), a layer disposed on the lower ITO layer and including Ag (hereinafter, referred to as an Ag layer), and a layer disposed on the Ag layer and including the ITO (referred to as an upper ITO layer).

The sacrificial pattern SP may be disposed between the anode AE and the pixel defining film PDL. The sacrificial pattern SP may define (or have) a sacrificial opening OP-S through which a portion of an upper surface of the anode AE is exposed. The sacrificial opening OP-S may overlap the light emitting opening OP-E, which will be described below in a plan view.

The pixel defining film PDL may be disposed on the fifth insulating layer 50 of the circuit element layer DP-CL. The pixel defining film PDL may define (or have) the light emitting opening OP-E. The light emitting opening OP-E may correspond to the anode AE, and the pixel defining film PDL may expose at least a portion of the anode AE through the light emitting opening OP-E.

Further, the light emitting opening OP-E may correspond to the sacrificial opening OP-S of the sacrificial pattern SP. According to an embodiment, the upper surface of the anode AE may be spaced apart from the pixel defining film PDL on a cross section with the sacrificial pattern SP interposed therebetween, and accordingly, damage to the anode AE may be protected in a process of forming the light emitting opening OP-E.

An area of the light emitting opening OP-E may be smaller than an area of the sacrificial opening OP-S in a plan view. That is, an inner surface of the pixel defining film PDL defining the light emitting opening OP-E may be closer to a center of the anode AE than an inner surface of the sacrificial pattern SP defining the sacrificial opening OP-S. However, the present disclosure is not limited thereto, and the inner surface of the sacrificial pattern SP defining the sacrificial opening OP-S may be substantially aligned with the inner surface of the pixel defining film PDL defining the light emitting opening OP-E in another embodiment. In this case, the light emitting area PXA may be regarded as an area of the anode AE exposed from the corresponding sacrificial opening OP-S.

The pixel defining film PDL may include an inorganic insulating material. For example, the pixel defining film PDL may include a silicon nitride (SiNx). The pixel defining film PDL may be disposed between the anode AE and the auxiliary electrode SE and block electrical connection between the anode AE and the auxiliary electrode SE.

The light emitting pattern EP may be disposed on the anode AE. In detail, the light emitting pattern EP may be disposed on the anode AE, the pixel defining film PDL, and the auxiliary electrode SE. The light emitting pattern EP may include a light emitting layer including a light emitting material. The light emitting pattern EP may further include a hole injection layer (HIL) and a hole transport layer (HTL) arranged between the anode AE and the light emitting layer and may further include an electron transport layer (ETL) and an electron injection layer (EIL) arranged on the light emitting layer. The light emitting pattern EP may be referred to as an "organic layer" or an "intermediate layer."

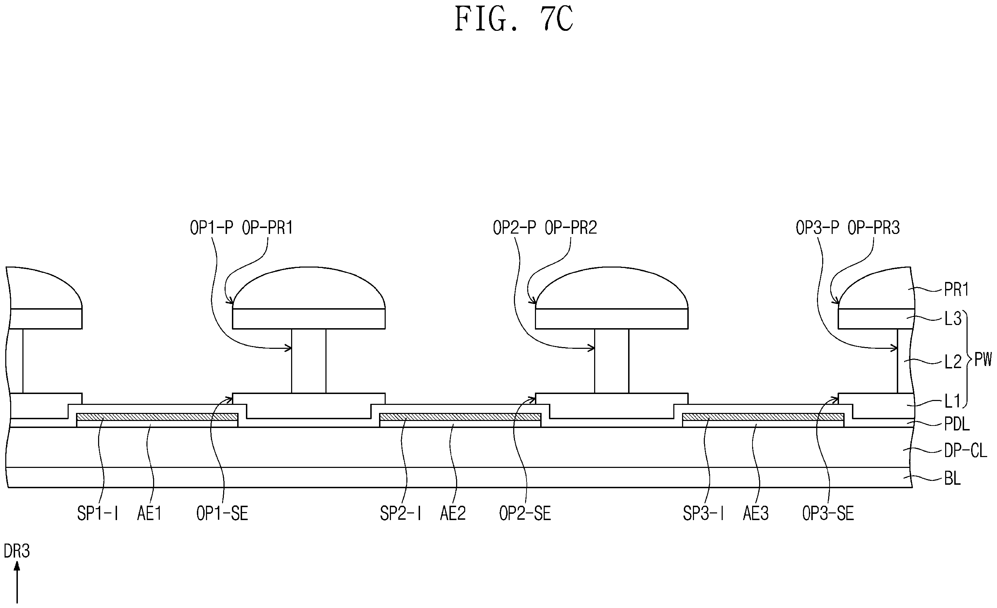

The light emitting pattern EP may be patterned by a tip portion defined by a partition wall PW (see FIG. 7C). Details will be described below in the description of a method of manufacturing the display panel. The light emitting pattern EP may be disposed inside the sacrificial opening OP-S, the light emitting opening OP-E, and the auxiliary opening OP-SE. However, this is illustratively illustrated, and the light emitting pattern EP may be disposed inside at least one opening among the sacrificial opening OP-S, the light emitting opening OP-E, and the auxiliary opening OP-SE. The light emitting pattern EP may cover portions of upper surfaces of the pixel defining film PDL and the auxiliary electrode SE.

The cathode CE may be disposed on the light emitting pattern EP. In detail, the cathode CE may be disposed on the light emitting pattern EP and the auxiliary electrode SE. A distal end of the cathode CE may be in direct contact with an upper surface U_SE of the auxiliary electrode SE. Alternatively, the cathode CE may be in direct contact with a side surface S_SE of the auxiliary electrode SE (not shown). That is, the cathode CE may be deposited wider than the light emitting pattern EP, may cover the light emitting pattern EP, and may be in direct contact with the upper surface U_SE and/or the side surface S_SE of the auxiliary electrode SE.

The cathode CE may be patterned by the tip portion (e.g., third partition wall layer L3 (see FIG. 7C)) defined by the partition wall PW. At least a portion of the cathode CE may be disposed in the auxiliary opening OP-SE. FIG. 5 illustratively illustrates that the cathode CE is disposed in the light emitting opening OP-E and the auxiliary opening OP-SE, but the present disclosure is not limited thereto. For another example, the cathode CE may be disposed only within the auxiliary opening OP-SE.

The cathode CE may be conductive. The cathode CE may be formed of various materials such as a metal, a transparent conductive oxide ("TCO"), and a conductive polymer material as long as the materials are conductive. For example, the cathode CE may include silver (Ag), magnesium (Mg), lead (Pb), copper (Cu), or compounds thereof. In an embodiment, the cathode CE does not include titanium (Ti) i.e. the cathode CE contains a different material from the auxiliary electrode SE.

In an embodiment of the present disclosure, the display element layer DP-OLED may further include the capping pattern CP. The capping pattern CP may be disposed on the cathode CE. The capping pattern CP may be patterned by the tip portion (e.g., third partition wall layer L3) defined by the partition wall PW. In an embodiment, the capping pattern CP may be omitted.

The auxiliary electrode SE may be disposed on the pixel defining film PDL. The auxiliary electrode SE may define the auxiliary opening OP-SE. The auxiliary opening OP-SE may overlap the light emitting opening OP-E and expose at least a portion of the anode AE in a plan view. In an embodiment, the auxiliary opening OP-SE may surround the light emitting opening OP-E in a plan view, an area of the auxiliary opening OP-SE may be greater than the light emitting opening OP-E in a plan view, and the auxiliary electrode SE may be located outside the light emitting opening OP-E in a plan view. The auxiliary electrode SE is disposed in the peripheral area NPXA, not in the light emitting area PXA, and the light emitting opening OP-E defines the light emitting area PXA.

The auxiliary electrode SE may be formed by sequentially laminating a plurality of layers and removing some layers. A detailed description thereof will be made below. The auxiliary electrode SE may include a conductive material. The conductive material may include a metal, a transparent conductive oxide (TCO), or a combination thereof. For example, the auxiliary electrode SE may include titanium (Ti).

The auxiliary electrode SE may receive a driving voltage, and the cathode CE may be electrically connected to the auxiliary electrode SE. Accordingly, the cathode CE may receive the driving voltage through the auxiliary electrode SE. FIG. 5 illustratively illustrates that an outer surface of the auxiliary electrode SE extends perpendicular to the upper surface of the pixel defining film PDL (i.e., extends in the third direction DR3), but the present disclosure is not limited thereto. For another example, the auxiliary electrode SE may have a tapered shape or a reverse tapered shape at its end.

The thin film encapsulation layer TFE may be disposed on the display element layer DP-OLED. The thin film encapsulation layer TFE may include a lower encapsulation inorganic pattern LIL, a common inorganic film CLIL, an encapsulation organic film OL, and an upper encapsulation inorganic film UIL.

The lower encapsulation inorganic pattern LIL may correspond to (or overlap) the light emitting opening OP-E in a plan view. The lower encapsulation inorganic pattern LIL may be disposed on the capping pattern CP to cover the light emitting element ED. That is, the lower encapsulation inorganic pattern LIL may be deposited wider than the light emitting element ED to cover the cathode CE and may be in direct contact with the upper surface U_SE of the auxiliary electrode SE. Further, a distal end of the lower encapsulation inorganic pattern LIL may extend in a thickness direction (i.e., the third direction DR3) of the base layer BL. The distal end of the lower encapsulation inorganic pattern LIL may protrude from the upper surface U_SE of the auxiliary electrode SE in a light emitting direction (for example, the third direction DR3).

The common inorganic film CLIL may cover the lower encapsulation inorganic pattern LIL and have an integral shape. The common inorganic film CLIL may include an inorganic material. For example, the common inorganic film CLIL may include at least one of a silicon nitride (SiNₓ) and a silicon oxy nitride (SiON).

The encapsulation organic film OL may be disposed on the common inorganic film CLIL. The encapsulation organic film OL may cover the common inorganic film CLIL and provide a flat upper surface. The upper encapsulation inorganic film UIL may be disposed on the encapsulation organic film OL. The lower encapsulation inorganic pattern LIL, the common inorganic film CLIL, and the upper encapsulation inorganic film UIL may protect the display element layer DP-OLED from moisture/oxygen, and the encapsulation organic film OL may protect the display element layer DP-OLED from foreign substances such as dust particles.

FIG. 5 illustratively illustrates that the thin film encapsulation layer TFE includes the lower encapsulation inorganic pattern LIL, the common inorganic film CLIL, the encapsulation organic film OL, and the upper encapsulation inorganic film UIL, but the present disclosure is not limited thereto. For another example, in an embodiment, the thin film encapsulation layer TFE may not include the common inorganic film CLIL.

Unlike a structure in which the cathode CE is in contact with a side surface of the partition wall PW (see FIG. 7C) containing aluminium (Al), in this embodiment, as the cathode CE is in direct contact with the auxiliary electrode SE containing titanium (Ti), contact defects caused by oxidation of the aluminium may be effectively reduced or eliminated, and as the cathode CE is in contact with the upper surface U_SE of the auxiliary electrode SE, a contact length may be increased. Further, the lower encapsulation inorganic pattern LIL is in direct contact with the upper surface U_SE of the auxiliary electrode SE while covering the cathode CE, and thus an inorganic material and a metallic material may be bonded to each other. Thus, contact reliability of the cathode CE may be effectively improved, and defects resulting from moisture penetration into the display panel DP may be reduced or eliminated.

Unlike a structure in which the patterning is performed using the partition wall PW and the partition wall PW remains in a final structure, the display panel DP may have a structure in which the partition wall PW is removed after the patterning and thus which is robust against an external impact, and light emitting efficiency of the light emitting element ED may be effectively increased by removing the partition wall PW positioned on a light emitting path.

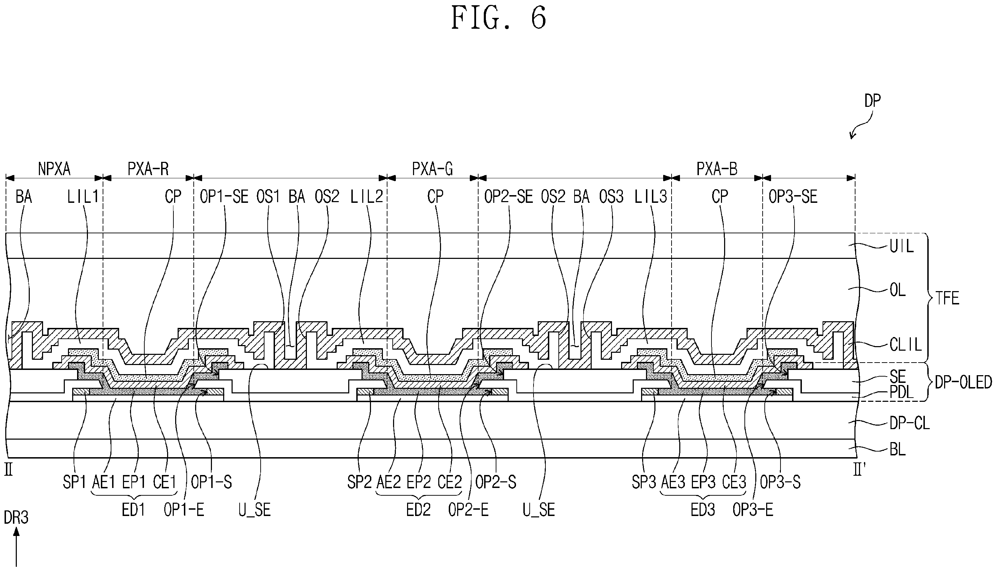

FIG. 6 is a cross-sectional view of the display panel DP along line II-II' of FIG. 4. FIG. 6 enlargedly illustrates one first light emitting area PXA-R, one second light emitting area PXA-G, and one third light emitting area PXA-B, and the description of the one light emitting area PXA of FIG. 5 may be equally applied to the first to third light emitting areas PXA-R, PXA-G, and PXA-B of FIG. 6. In description of FIG. 6, the same/similar reference numerals are used for the same/similar components described in FIG. 5, and a duplicated description thereof will be omitted.

Referring to FIG. 6, the display panel DP may include the base layer BL, the circuit element layer DP-CL, the display element layer DP-OLED, and the thin film encapsulation layer TFE. The display element layer DP-OLED may include light emitting elements ED1, ED2, and ED3, sacrificial patterns SP1, SP2, and SP3, the pixel defining film PDL, the capping pattern CP, and the auxiliary electrode SE.

The light emitting elements ED1, ED2, and ED3 may include the first light emitting element ED1, the second light emitting element ED2, and the third light emitting element ED3 that emit lights having different colors. The first light emitting element ED1 may be provided as a plurality of first light emitting elements ED1, the second light emitting element ED2 may be provided as a plurality of second light emitting elements ED2, and the third light emitting element ED3 may be provided as a plurality of third light emitting elements ED3. However, for convenience of description, the first light emitting element ED1, the second light emitting element ED2, and the third light emitting element ED3 are expressed in singular forms below.

The first light emitting element ED1 may include a first anode AE1, a first light emitting pattern EP1, and a first cathode CE1. The second light emitting element ED2 may include a second anode AE2, a second light emitting pattern EP2, and a second cathode CE2. The third light emitting element ED3 may include a third anode AE3, a third light emitting pattern EP3, and a third cathode CE3. The first to third anodes AE1, AE2, and AE3 may be provided as a plurality of patterns. In an embodiment, the first light emitting pattern EP1 may provide a red light, the second light emitting pattern EP2 may provide a green light, and the third light emitting pattern EP3 may provide a blue light.

First to third light emitting openings OP1-E, OP2-E, and OP3-E may be defined in the pixel defining film PDL. The first light emitting opening OP1-E may expose at least a portion of the first anode AE1. The second light emitting opening OP2-E may expose at least a portion of the second anode AE2. The third light emitting opening OP3-E may expose at least a portion of the third anode AE3.

In an embodiment, the first light emitting area PXA-R may be defined as an area of an upper surface of the first anode AE1, which is exposed by the first light emitting opening OP1-E. The second light emitting area PXA-G may be defined as an area of an upper surface of the second anode AE2, which is exposed by the second light emitting opening OP2-E. The third light emitting area PXA-B may be defined as an area of an upper surface of the third anode AE3, which is exposed by the third light emitting opening OP3-E.

The sacrificial patterns SP1, SP2, and SP3 may include the first sacrificial pattern SP1, the second sacrificial pattern SP2, and the third sacrificial pattern SP3. The first to third sacrificial patterns SP1, SP2, and SP3 may be arranged on upper surfaces of the first to third anodes AE1, AE2, and AE3, respectively. First to third sacrificial openings OP1-S, OP2-S, and OP3-S overlapping the first to third light emitting openings OP1-E, OP2-E, and OP3-E in a plan view may be defined in the first to third sacrificial patterns SP1, SP2, and SP3, respectively.

First to third auxiliary openings OP1-SE, OP2-SE, and OP3-SE overlapping the first to third light emitting openings OP1-E, OP2-E, and OP3-E in a plan view may be defined in the auxiliary electrode SE, respectively.

In an embodiment, the first to third light emitting patterns EP1, EP2, and EP3 and the first to third cathodes CE1, CE2, and CE3 may be physically separated by a third partition wall layer L3 (see FIG. 7C) and thus may be formed inside the sacrificial openings OP1-S, OP2-S, and OP3-S, the light emitting openings OP1-E, OP2-E, and OP3-E, and the auxiliary openings OP1-SE, OP2-SE, and OP3-SE. Further, the first to third light emitting patterns EP1, EP2, and EP3 may cover the portions of the upper surfaces of the pixel defining film PDL and the auxiliary electrode SE.

That is, the first light emitting element ED1 may be formed inside the first sacrificial opening OP1-S, the first light emitting opening OP1-E, and the first auxiliary opening OP1-SE and disposed on the pixel defining film PDL and the auxiliary electrode SE. The second light emitting element ED2 may be formed inside the second sacrificial opening OP2-S, the second light emitting opening OP2-E, and the second auxiliary opening OP2-SE and disposed on the pixel defining film PDL and the auxiliary electrode SE. The third light emitting element ED3 may be formed inside the third sacrificial opening OP3-S, the third light emitting opening OP3-E, and the third auxiliary opening OP3-SE and disposed on the pixel defining film PDL and the auxiliary electrode SE. The first to third light emitting elements ED1, ED2, and ED3 may be spaced apart from each other. In an embodiment, two adjacent cathode (e.g., CE1 and CE2) may be electrically connected to the auxiliary electrode SE therebetween.

According to the present disclosure, the plurality of first light emitting patterns EP1 may be patterned and deposited in units of pixels by the tip portion defined in the partition wall PW (see FIG. 7C), which will be described below. That is, the first light emitting patterns EP1 may be commonly formed using an open mask but may be easily divided in units of pixels by the partition wall PW.

On the other hand, when the first light emitting patterns EP1 are patterned using a fine metal mask ("FMM"), a support spacer protruding from the conductive partition wall to support the FMM should be provided. Further, since the FMM is spaced apart from a base surface, on which the patterning is performed, by a height of the partition wall PW and the spacer, implementation in a high resolution may be limited. Further, as the FMM is in contact with the spacer, after the patterning process for the first light emitting patterns EP1, foreign substances may remain on the spacer, and the spacer may be damaged due to stamping of the mask. Accordingly, a defective display panel may be formed.

According to an embodiment, in a process of manufacturing a display panel DP, the partition wall PW is included so that physical separation between the light emitting elements ED1, ED2, and ED3 may be easily performed. Accordingly, current leakage or driving errors between the adjacent light emitting areas PXA-R, PXA-G, and PXA-B may be prevented, and independent driving for each of the light emitting elements ED1, ED2, and ED3 may be performed.

In particular, since the plurality of first light emitting patterns EP1 are patterned without a mask in contact with an inner component inside the display area DA (see FIG. 1B), a defect rate is effectively reduced, and thus the display panel DP having improved process reliability may be provided. As the patterning may be performed even when the separate support spacer protruding from the partition wall PW is not provided, areas of the light emitting areas PXA-R, PXA-G, and PXA-B may be miniaturized, and thus the display panel DP that easily implements a high resolution may be provided.

Further, in manufacturing a large-area display panel DP, the display panel DP may be provided in which process costs may be reduced as production of a large-area mask is omitted, and process reliability may be improved as the display panel DP is not affected by defects that may occur in the large-area mask. The description of the plurality of first light emitting patterns EP1 may be equally applied even to the plurality of second and third light emitting patterns EP2 and EP3.

The thin film encapsulation layer TFE may include a plurality of lower encapsulation inorganic patterns LIL1, LIL2, and LIL3, the common inorganic film CLIL, the encapsulation organic film OL, and the upper encapsulation inorganic film UIL.

The plurality of lower encapsulation inorganic patterns LIL1, LIL2, and LIL3 may include the first lower encapsulation inorganic pattern LIL1 that covers the first light emitting element ED1, a second lower encapsulation inorganic pattern LIL2 that coves the second light emitting element ED2, and the third lower encapsulation inorganic pattern LIL3 that covers the third light emitting element ED3. The first to third lower encapsulation inorganic patterns LIL1, LIL2, and LIL3 may overlap the first to third light emitting openings OP1-E, OP2-E, and OP3-E, respectively in a plan view. The first to third lower encapsulation inorganic patterns LIL1, LIL2, and LIL3 may be provided in the form of patterns spaced apart from each other.

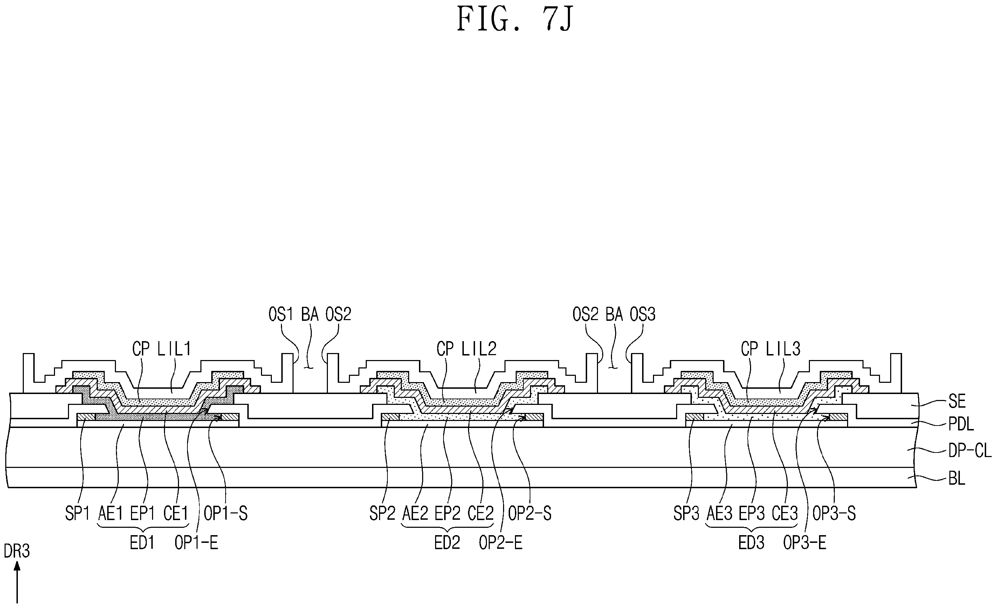

Outer surfaces OS1, OS2, and OS3 of the plurality of lower encapsulation inorganic patterns LIL1, LIL2, and LIL3 may define gap areas BA (See FIG. 7J). For example, the gap areas BA may be defined between the outer surface OS1 of the first lower encapsulation inorganic pattern LIL1 and the outer surface OS2 of the second lower encapsulation inorganic pattern LIL2 and between the outer surface OS2 of the second lower encapsulation inorganic pattern LIL2 and the outer surface OS3 of the third lower encapsulation inorganic pattern LIL3.

The common inorganic film CLIL may cover the first to third lower encapsulation inorganic patterns LIL1, LIL2, and LIL3 and have an integral shape. The common inorganic film CLIL may cover the outer surfaces OS1, OS2, and OS3 of the plurality of lower encapsulation inorganic patterns LIL1, LIL2, and LIL3 and the upper surface U_SE of the auxiliary electrode SE. For example, the common inorganic film CLIL may cover the outer surface OS1 of the first lower encapsulation inorganic pattern LIL1, the upper surface U_SE of the auxiliary electrode SE, and the outer surface OS2 of the second lower encapsulation inorganic pattern LIL2 and may cover the outer surface OS2 of the second lower encapsulation inorganic pattern LIL2, the upper surface U_SE of the auxiliary electrode SE, and the outer surface OS3 of the third lower encapsulation inorganic pattern LIL3.

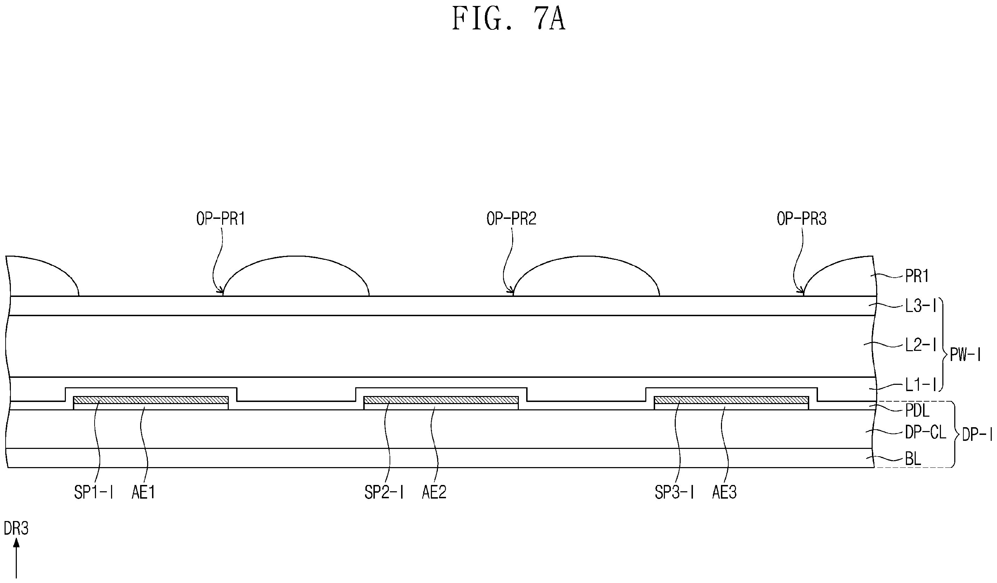

FIGS. 7A to 7L are cross-sectional views illustrating some of the operations of a method of manufacturing the display panel DP according to an embodiment of the present disclosure. In description of FIGS. 7A to 7L, the same/similar reference numerals will be used for the same/similar components with reference to FIGS. 1 to 6, and duplicated descriptions thereof will be omitted.

A method of manufacturing a display panel according to an embodiment of the present disclosure may include: an operation of providing a preliminary display panel including a base layer and a pixel defining film disposed on the base layer, an operation of forming a preliminary partition wall including a first preliminary partition wall layer, a second preliminary partition wall layer, and a third preliminary partition wall layer and disposed on the preliminary display panel, an operation of forming a partition wall defining a plurality of partition wall openings therein from the preliminary partition wall and including a first partition wall layer, a second partition wall layer, and a third partition wall layer, an operation of forming a plurality of light emitting openings overlapping the plurality of partition wall openings by etching the pixel defining film, an operation of forming a plurality of light emitting elements disposed on the pixel defining film and the first partition wall layer, an operation of forming a plurality of lower encapsulation inorganic patterns covering the plurality of light emitting elements disposed on the light emitting element and the first partition wall layer, and an operation of forming an auxiliary electrode by removing the second preliminary partition wall layer and the third preliminary partition wall layer.

Hereinafter, a method of forming the three light emitting elements ED1, ED2, and ED3, the lower encapsulation inorganic patterns LIL1, LIL2, and LIL3 that cover the light emitting elements ED1, ED2, and ED3, the common inorganic film CLIL, the encapsulation organic film OL, and the upper encapsulation inorganic film UIL will be described through FIGS. 7A to 7L. The display panel DP formed through FIGS. 7A to 7L may correspond to the display panel DP of FIG. 6.

Referring to FIG. 7A, the method of manufacturing a display panel according to the present disclosure may include an operation of providing a preliminary display panel DP-I. The preliminary display panel DP-I provided in an embodiment may include the base layer BL, the circuit element layer DP-CL, the first to third anodes AE1, AE2, and AE3, first to third preliminary sacrificial patterns SP1-I, SP2-I, and SP3-I, and the pixel defining film PDL.

The circuit element layer DP-CL may be formed by a general method of manufacturing a circuit element, in which an insulating layer, a semiconductor layer, and a conductive layer are formed through a coating method or a deposition method, the insulating layer, the semiconductor layer, and the conductive layer are selectively patterned by a photolithography and etching process, and a semiconductor pattern, a conductive pattern, a signal line or the like are formed.

The first anode AE1 and the first preliminary sacrificial pattern SP1-I may be formed by the same patterning process, the second anode AE2 and the second preliminary sacrificial pattern SP2-I may be formed by the same patterning process, and the third anode AE3 and the third preliminary sacrificial pattern SP3-I may be formed by the same patterning process. The pixel defining film PDL may be disposed on the base layer BL. The pixel defining film PDL may cover all the first to third anodes AE1, AE2, and AE3 and the first to third preliminary sacrificial patterns SP1-I, SP2-I, and SP3-I.

The method of manufacturing a display panel according to the present disclosure may include an operation of forming a preliminary partition wall PW-I on the preliminary display panel DP-I. The preliminary partition wall PW-I may include a first preliminary partition wall layer L1-I, a second preliminary partition wall layer L2-I, and a third preliminary partition wall layer L3-I.

The first preliminary partition wall layer L1-I may be formed on the pixel defining film PDL, the second preliminary partition wall layer L2-I may be formed on the first preliminary partition wall layer L1-I, and the third preliminary partition wall layer L3-I may be formed on the second preliminary partition wall layer L2-I. The first to third preliminary partition wall layers L1-I, L2-I, and L3-I may be formed through a process of depositing a conductive material. The first to third preliminary partition wall layers L1-I, L2-I, and L3-I may include a metal, a transparent conductive oxide (TCO), or a combination thereof. For example, the operation of forming the preliminary partition wall PW-I may include an operation of depositing the first preliminary partition wall layer L1-I containing titanium (Ti), an operation of depositing the second preliminary partition wall layer L2-I containing aluminium (Al), and an operation of depositing the third preliminary partition wall layer L3-I containing titanium (Ti).

The materials of the first to third preliminary partition wall layers L1-I, L2-I, and L3-I are not limited to the above example. For example, the first to third preliminary partition wall layers L1-I, L2-I, and L3-I may include gold (Au), silver (Ag), aluminium (Al), magnesium (Mg), lithium (Li), molybdenum (Mo), titanium (Ti), copper (Cu), or an alloy and may include an indium tin oxide ("ITO"), an indium zinc oxide ("IZO"), a zinc oxide, an indium oxide, an indium gallium oxide, an indium gallium zinc oxide ("IGZO"), or an aluminium zinc oxide.

Further, the method of manufacturing a display panel according to the present disclosure may include an operation of forming a first photoresist layer PR1 on the preliminary partition wall PW-I. The first photoresist layer PR1 may be formed by forming a preliminary photoresist layer on the preliminary partition wall PW-I and then patterning the preliminary photoresist layer using a photo mask. A first photo opening OP-PR1, a second photo opening OP-PR2, and a third photo opening OP-PR3 may be formed in the first photoresist layer PR1 through a patterning process. The first photo opening OP-PR1 may overlap the first anode AE1, the second photo opening OP-PR2 may overlap the second anode AE2, and the third photo opening OP-PR3 may overlap the third anode AE3 in a plan view.

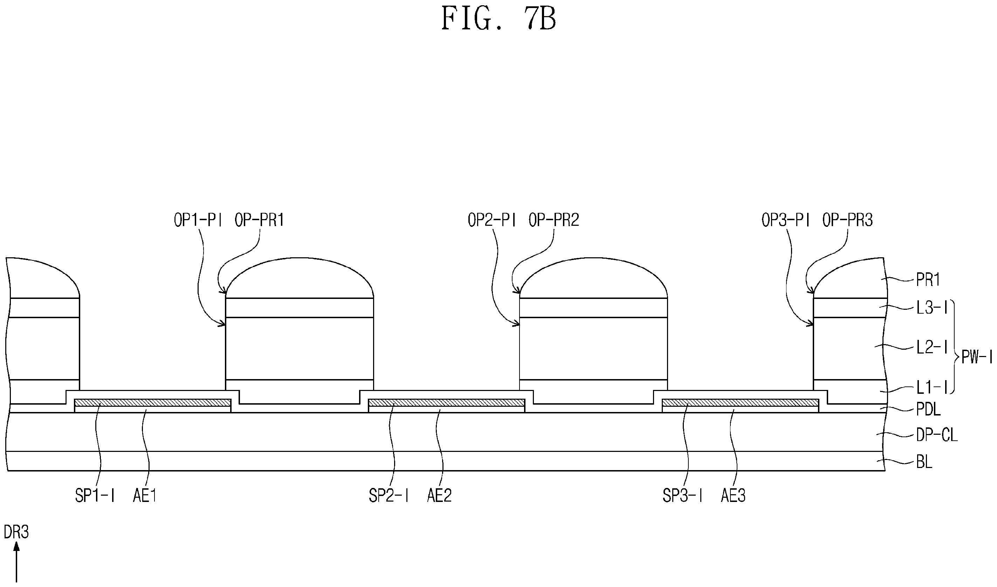

Thereafter, referring to FIGS. 7B and 7C, the method of manufacturing a display panel according to the present disclosure may include an operation of forming the partition wall PW having partition wall openings OP1-P, OP2-P, and OP3-P from the preliminary partition wall PW-I (see FIG. 7A). The operation of forming the partition wall PW may include an operation of dry etching the first to third preliminary partition wall layers L1-I, L2-I, and L3-I and an operation of wet etching the second preliminary partition wall layer L2-I.

First, as illustrated in FIG. 7B, in the operation of dry etching the first to third preliminary partition wall layers L1-I, L2-I, and L3-I, the first preliminary partition wall layer L1-I, the second preliminary partition wall layer L2-I, and the third preliminary partition wall layer L3-I may be dry etched using the first photoresist layer PR1 as a mask. A portion of the preliminary partition wall PW-I, which does not overlap the first photoresist layer PR1 in a plan view, may be etched and removed. For example, a first preliminary partition wall opening OP1-PI may be formed at a portion that overlaps and is removed from the first photo opening OP-PR1, a second preliminary partition wall opening OP2-PI may be formed at a portion that overlaps and is removed from the second photo opening OP-PR2, and a third preliminary partition wall opening OP3-PI may be formed at a portion that overlaps and is removed from the third photo opening OP-PR3.

A primary dry etching process in an embodiment may be performed in an etching environment in which etching selection ratios between the first preliminary partition wall layer L1-I, the second preliminary partition wall layer L2-I, and the third preliminary partition wall layer L3-I are substantially the same. Accordingly, an inner surface of the first preliminary partition wall layer L1-I, an inner surface of the second preliminary partition wall layer L2-I, and an inner surface of the third preliminary partition wall layer L3-I, which define the preliminary partition wall openings OP1-PI, OP2-PI, and OP3-PI, may be substantially aligned.

Thereafter, as illustrated in FIG. 7C, in the operation of wet etching the second preliminary partition wall layer L2-I (see FIG. 7B), the second preliminary partition wall layer L2-I may be wet etched using the first photoresist layer PR1 as a mask. Accordingly, a portion of the second preliminary partition wall layer L2-I may be etched to form the partition wall openings OP1-P, OP2-P, and OP3-P. The partition wall openings OP1-P, OP2-P, and OP3-P may include the first partition wall opening OP1-P, the second partition wall opening OP2-P, and the third partition wall opening OP3-P. The first partition wall opening OP1-P may be formed to overlap the first anode AE1, the second partition wall opening OP2-P may be formed to overlap the second anode AE2, and the third partition wall opening OP3-P may be formed to overlap the third anode AE3 in a plan view. Further, the auxiliary openings OP1-SE, OP2-SE, and OP3-SE are formed in the partition wall layers L1. The first partition wall layer L1, the second partition wall layer L2, and the third partition wall layer L3 that are formed through etching may form the partition wall PW.

The secondary wet etching process in the present disclosure may be performed in an environment in which etching selection ratios between the first and third preliminary partition wall layers L1-I and L3-I (see FIG. 7B) and the second preliminary partition wall layer L2-I (see FIG. 7B) are high. Accordingly, an inner surface of the partition wall PW that defines the partition wall openings OP1-P, OP2-P, and OP3-P may have an undercut shape on a cross section. In detail, an etch rate of the second preliminary partition wall layer L2-I with respect to an etching solution is greater than an etch rate of the first and third preliminary partition wall layers L1-I and L3-I, and thus the second preliminary partition wall layer L2-I may be mainly etched. Accordingly, the second partition wall layer L2 may be formed to be recessed inward as compared to the first and third partition wall layers L1 and L3. The tip portion may be formed in the partition wall PW by portions of the first and third partition wall layers L1 and L3 that further protrude from the second partition wall layer L2.

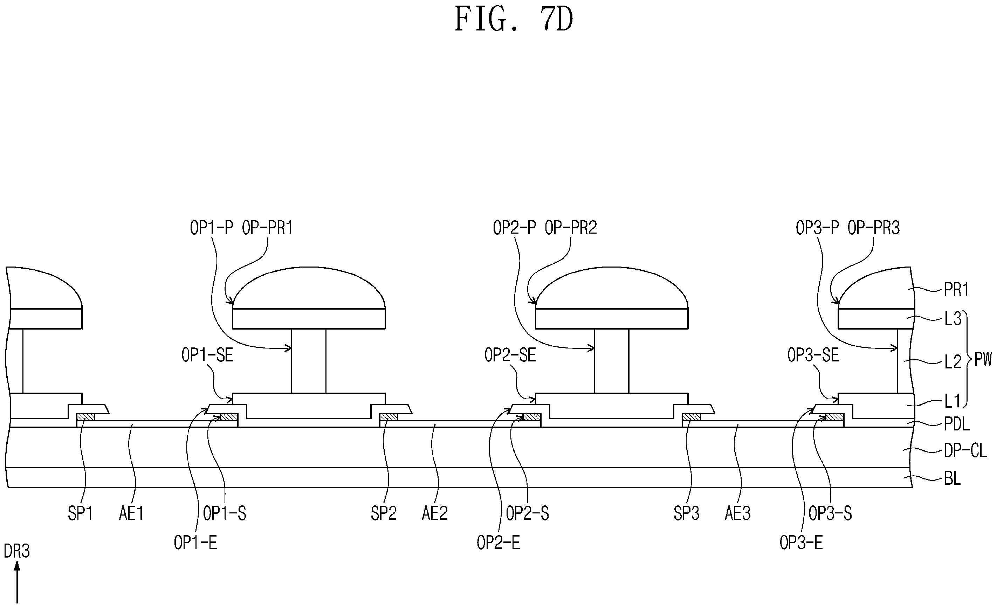

Thereafter, referring to FIG. 7D, the method of manufacturing a display panel according to the present disclosure may include an operation of etching the pixel defining film PDL to form the light emitting openings OP1-E, OP2-E, and OP3-E that overlap the plurality of partition wall openings OP1-P, OP2-P, and OP3-P in a plan view, respectively.

In the operation of etching the pixel defining film PDL, the pixel defining film PDL may be dry etched using the first photoresist layer PR1 and the partition wall PW (e.g., the third partition wall layer L3) as a mask. A portion of the pixel defining film PDL, which does not overlap the first photoresist layer PR1 and the partition wall PW in a plan view, may be etched and removed. As a result, the light emitting openings OP1-E, OP2-E, and OP3-E that overlap the partition wall openings OP1-P, OP2-P, and OP3-P in a plan view, respectively, may be formed in the pixel defining film PDL. The light emitting openings OP1-E, OP2-E, and OP3-E may include the first light emitting opening OP1-E that overlaps the first partition wall opening OP1-P, the second light emitting opening OP2-E that overlaps the second partition wall opening OP2-P, and the third light emitting opening OP3-E that overlaps the third partition wall opening OP3-P in a plan view.

Thereafter, the method of manufacturing a display panel according to the present disclosure may further include an operation of etching the first to third preliminary sacrificial patterns SP1-I, SP2-I, and SP3-I (see FIG. 7C) to form the sacrificial patterns SP1, SP2, and SP3 having the sacrificial openings OP1-S, OP2-S, and OP3-S overlapping the light emitting openings OP1-E, OP2-E, and OP3-E in a plan view, respectively.

In the operation of etching the first to third preliminary sacrificial patterns SP1-I, SP2-I, and SP3-I, the first to third preliminary sacrificial patterns SP1-I, SP2-I, and SP3-I may be wet etched using the first photoresist layer PR1 and the partition wall PW (e.g., the third partition wall layer L3) as a mask. Portions of the first to third preliminary sacrificial patterns SP1-I, SP2-I, and SP3-I, which do not overlap the first photoresist layer PR1 and the partition wall PW in a plan view, may be etched and removed. As a result, the sacrificial patterns SP1, SP2, and SP3 may be formed from the first to third preliminary sacrificial patterns SP1-I, SP2-I, and SP3-I.

The sacrificial patterns SP1, SP2, and SP3 may include the first sacrificial pattern SP1, the second sacrificial pattern SP2, and the third sacrificial pattern SP3. The first sacrificial opening OP1-S that overlaps the first light emitting opening OP1-E in a plan view may be formed in the first sacrificial pattern SP1, the second sacrificial opening OP2-S that overlaps the second light emitting opening OP2-E in a plan view may be formed in the second sacrificial pattern SP2, and the third sacrificial opening OP3-S that overlaps the third light emitting opening OP3-E in a plan view may be formed in the third sacrificial pattern SP3.

An etching process of the sacrificial patterns SP1, SP2, and SP3 may be performed in an environment in which etch selection ratios between the sacrificial patterns SP1, SP2, and SP3 and the anodes AE1, AE2, and AE3 are high, and therefore, the anodes AE1, AE2, and AE3 may be prevented from being etched together. That is, the sacrificial patterns SP1, SP2, and SP3 having higher etch rates than those of the anodes AE1, AE2, and AE3 are arranged between the pixel defining film PDL and the anodes AE1, AE2, and AE3, and thus the anodes AE1, AE2, and AE3 may be prevented from being etched and damaged together during the etching process.

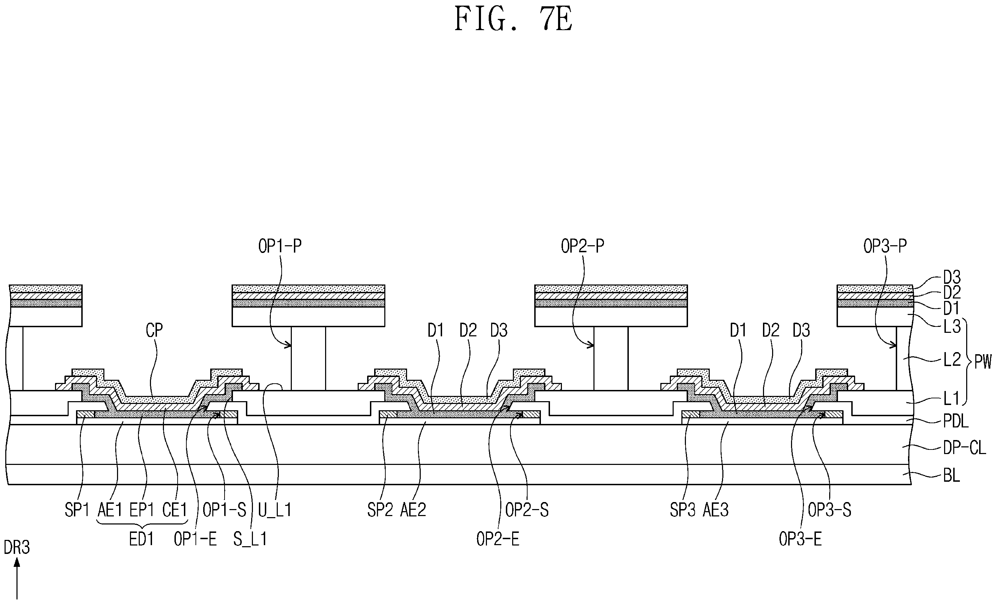

Thereafter, referring to FIG. 7E, the method of manufacturing a display panel according to the present disclosure may include an operation of forming the plurality of light emitting elements (e.g., the first light emitting element ED1) on the pixel defining film PDL and the first partition wall layer L1 after the first photoresist layer PR1 (see FIG. 7D) is removed. The operation of forming the plurality of light emitting elements ED (see FIG. 5) may include an operation of forming the light emitting pattern (e.g., the first light emitting pattern EP1) on the pixel defining film PDL and the first partition wall layer L1 and an operation of forming a cathode (e.g., the first cathode CE1) on the light emitting pattern (e.g., the first light emitting pattern EP1) so that a distal end of the cathode is in contact with an upper surface U_L1 of the first partition wall layer L1. Further, the cathode may be formed in contact with a side surface S_L1 of the first partition wall layer L1, and the cathode may be formed in contact with the upper surface U_L1 and the side surface S_L1 of the first partition wall layer L1.

The operation of forming the first light emitting pattern EP1 may include a process of depositing the light emitting layer. For example, the operation of forming the first light emitting pattern EP1 may include an operation of thermally evaporating the light emitting layer. The light emitting layer may be separated by the tip portion formed in the partition wall PW and may be deposited inside the first to third sacrificial openings OP1-S, OP2-S, and OP3-S, the first to third light emitting openings OP1-E, OP2-E, and OP3-E, and the first to third partition wall openings OP1-P, OP2-P, and OP3-P and on the partition wall PW. The light emitting layer formed inside the first sacrificial opening OP1-S, the first light emitting opening OP1-E, and the first partition wall opening OP1-P may form the first light emitting pattern EP1, and the light emitting layer formed inside the second and third partition wall openings OP2-P and OP3-P and on the partition wall PW may form a first dummy layer D1. That is, the first light emitting pattern EP1 may be formed on the first anode AE1 to overlap the first partition wall opening OP1-P in a plan view, and the first light emitting pattern EP1 may be formed to cover the first anode AE1 and the pixel defining film PDL.

The first dummy layer D1 formed together in the operation of forming the first light emitting pattern EP1 may include an organic material. For example, the first dummy layer D1 may include the same material as the material of the first light emitting pattern EP1. The first dummy layer D1 may be formed simultaneously together with the first light emitting pattern EP1 through a single process and may be separated from the first light emitting pattern EP1 by the undercut shape of the partition wall PW.

The operation of forming the first cathode CE1 may include a process of depositing a cathode layer. For example, the operation of forming the first cathode CE1 may include an operation of sputtering the cathode layer. An angle at which the cathode layer is deposited may be greater than an angle at which the above-described light emitting layer is deposited. For example, when an angle formed between a direction (e.g., the third direction DR3) perpendicular to the base layer BL and a depositing material is referred to as an input angle, the input angle of the cathode layer may be greater than the input angle of the light emitting layer.

The cathode layer may be separated by the tip portion formed in the partition wall PW and may be deposited inside the first to third light emitting openings OP1-E, OP2-E, and OP3-E and the first to third partition wall openings OP1-P, OP2-P, and OP3-P and on the partition wall PW. The cathode layer formed in the first light emitting opening OP1-E and the first partition wall opening OP1-P may form the first cathode CE1, and the cathode layer formed inside the second and third partition wall openings OP2-P and OP3-P and on the partition wall PW may form a second dummy layer D2. The first cathode CE1 may be formed on the first light emitting pattern EP1 to overlap the first partition wall opening OP1-P in a plan view. Further, the first cathode CE1 may be formed to cover the first light emitting pattern EP1 by the input angle of the cathode layer, which is greater than the input angle of the light emitting layer, and may be formed in contact with the upper surface U_L1 of the first partition wall layer L1. The first cathode CE1 may be formed in contact with the side surface S_L1 of the first partition wall layer L1, and the first cathode CE1 may be formed in contact with the side surface S_L1 and the upper surface U_L1 of the first partition wall layer L1.

The second dummy layer D2 formed together in the operation of forming the first cathode CE1 may include a conductive material. For example, the second dummy layer D2 may include the same material as the material of the first cathode CE1. The second dummy layer D2 may be formed simultaneously together with the first cathode CE1 through a single process and may be separated from the first cathode CE1 by the undercut shape of the partition wall PW.

The first anode AE1, the first light emitting pattern EP1, and the first cathode CE1 may be sequentially laminated in the third direction DR3. The first anode AE1, the first light emitting pattern EP1, and the first cathode CE1 may form the first light emitting element ED1.

The method of manufacturing a display panel according to the present disclosure may include an operation of forming the capping pattern CP. The operation of forming the capping pattern CP may include a process of depositing a capping pattern layer. The capping pattern layer may be separated by the tip portion formed in the partition wall PW and may be deposited inside the first to third partition wall openings OP1-P, OP2-P, and OP3-P and on the partition wall PW. The capping pattern layer formed inside the first partition wall opening OP1-P may form the capping pattern CP, and the capping pattern layer formed inside the second and third partition wall openings OP2-P and OP3-P and on the partition wall PW may form a third dummy layer D3.

The third dummy layer D3 formed together in the operation of forming the capping pattern CP may include a conductive material. For example, the third dummy layer D3 may include the same material as the material of the capping pattern CP. The third dummy layer D3 may be formed simultaneously together with the capping pattern CP through a single process and may be separated from the capping pattern CP by the undercut shape of the partition wall PW. In an embodiment of the present disclosure, a process of forming the capping pattern CP and the third dummy layer D3 may be omitted.

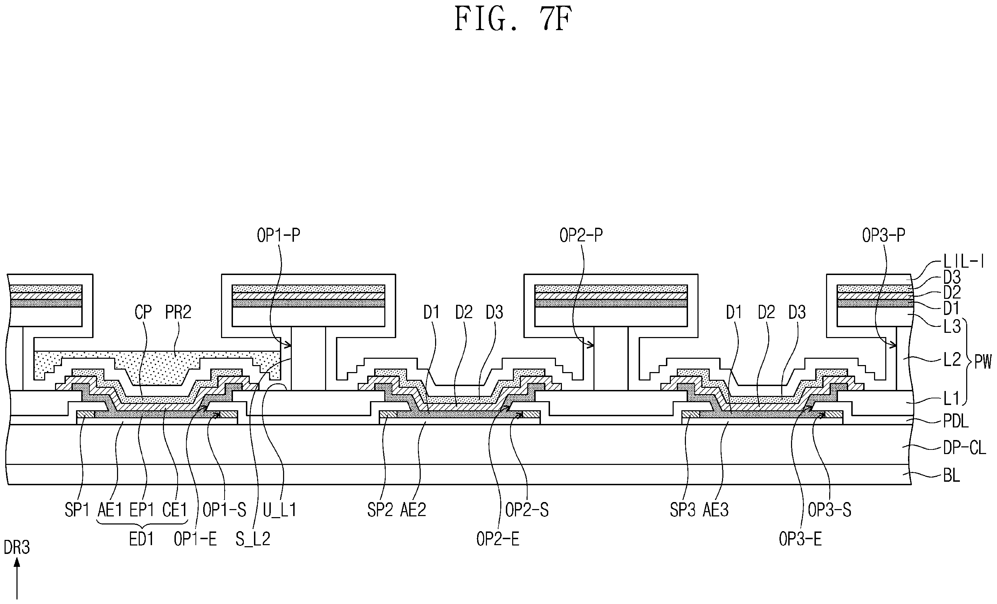

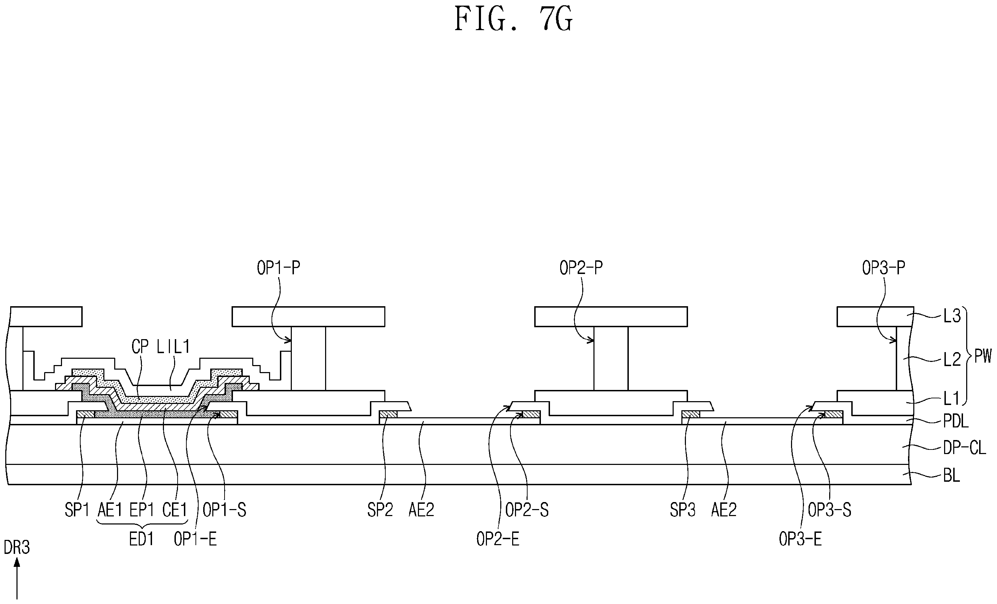

Thereafter, referring to FIGS. 7F and 7G, the method of manufacturing a display panel according to the present disclosure may include an operation of forming a plurality of lower encapsulation inorganic patterns (e.g., the first lower encapsulation inorganic patterns LIL1) that cover the plurality of light emitting elements (e.g. the first emitting element ED1) on the light emitting elements and the first partition wall layer L1.

First, referring to FIG. 7F, the operation of forming the first lower encapsulation inorganic pattern LIL1 may include an operation of depositing a lower encapsulation inorganic layer LIL-I. The lower encapsulation inorganic layer LIL-I may be formed through a deposition process. In an embodiment, the lower encapsulation inorganic layer LIL-I may be formed through a chemical vapor deposition ("CVD") process. The lower encapsulation inorganic layer LIL-I may be deposited to cover the first cathode CE1 and to be in direct contact with the upper surface U_L1 of the first partition wall layer L1. Further, the lower encapsulation inorganic layer LIL-I may be deposited to be in contact with the upper surface U_L1 of the first partition wall layer L1 and a side surface S_L2 of the second partition wall layer L2.

Thereafter, the method of manufacturing a display panel according to the present disclosure may include an operation of forming a second photoresist layer PR2. In the operation of forming the second photoresist layer PR2, the second photoresist layer PR2 may be formed by forming a preliminary photoresist layer and then patterning the preliminary photoresist layer using a photo mask. Through the patterning process, the second photoresist layer PR2 may be formed in the form of a pattern corresponding to the first light emitting element ED1.

Thereafter, referring to FIG. 7G, the operation of forming the first lower encapsulation inorganic pattern LIL1 may include an operation of removing a portion of the lower encapsulation inorganic layer LIL-I (see FIG. 7F), which does not overlap the first light emitting element ED1 in a plan view.

In the operation of removing the portion of the lower encapsulation inorganic layer LIL-I, which does not overlap the first light emitting element ED1 in a plan view, the lower encapsulation inorganic layer LIL-I may be dry etched using the second photoresist layer PR2 as a mask. A portion of the lower encapsulation inorganic layer LIL-I, which does not overlap the second photoresist layer PR2 in a plan view, may be removed, and the first lower encapsulation inorganic pattern LIL1 may be formed in the remaining portion of the lower encapsulation inorganic layer LIL-I, which is not etched.

Thereafter, the method of manufacturing a display panel according to the present disclosure may include an operation of removing the dummy layers D1, D2, and D3 (see FIG. 7F). Among the dummy layers D1, D2, and D3, the second and third dummy layers D2 and D3 may be removed through wet etching, and among the dummy layers D1, D2, and D3, the first dummy layer D1 may be removed through a stripper.

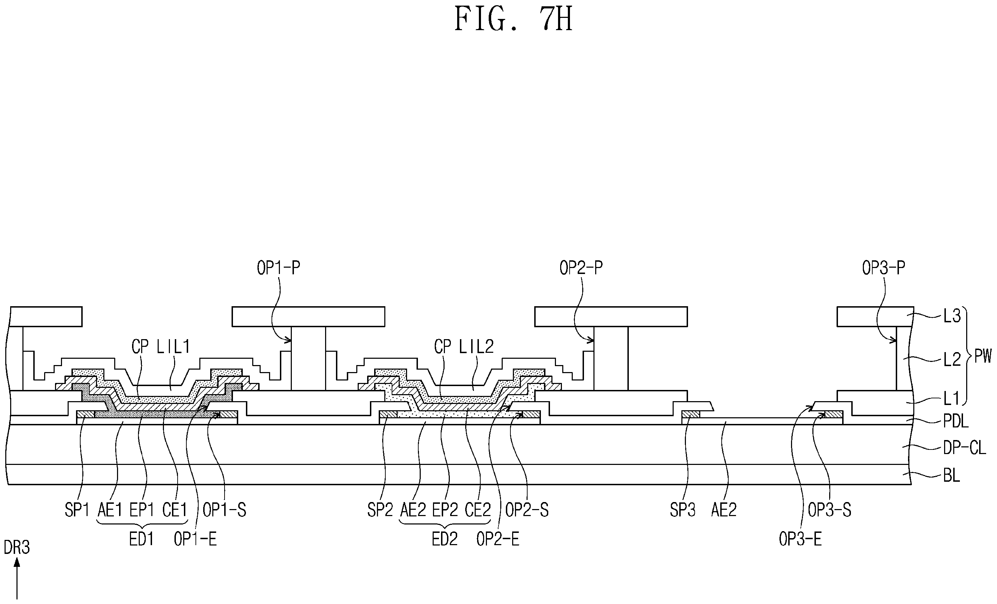

Thereafter, referring to FIG. 7H, in the method of manufacturing a display panel according to the present disclosure, after the second photoresist layer PR2 (see FIG. 7G) is removed, the second light emitting element ED2, the capping pattern CP, and the second lower encapsulation inorganic pattern LIL2 may be formed. The process of forming the second light emitting element ED2, the capping pattern CP, and the second lower encapsulation inorganic pattern LIL2 may be substantially the same as the process of forming the first light emitting element ED1, the capping pattern CP, and the first lower encapsulation inorganic pattern LIL1, which is described through FIGS. 7E to 7G.

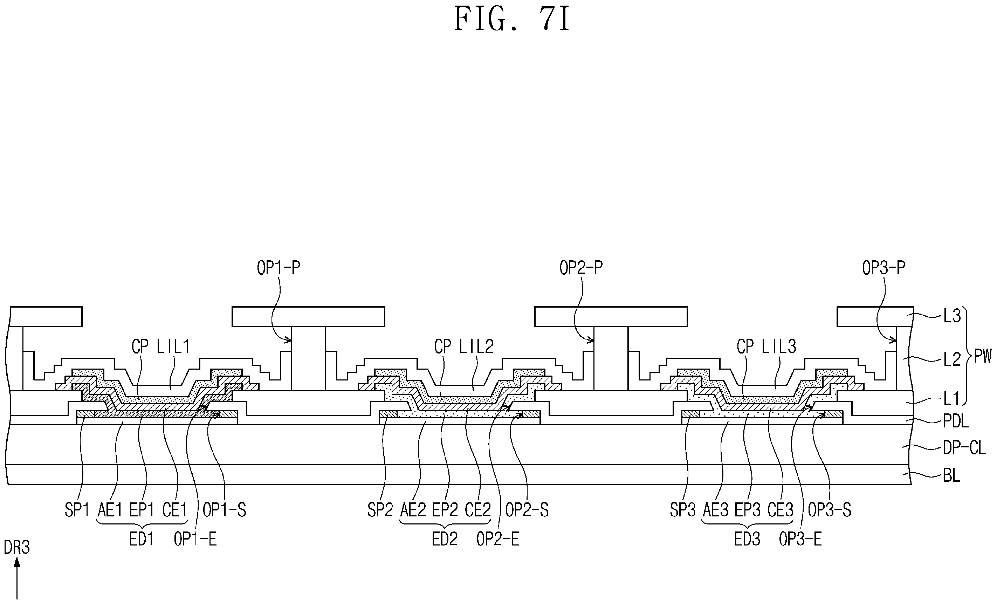

Referring to FIG. 7I, in the method of manufacturing a display panel according to the present disclosure, the third light emitting element ED3, the capping pattern CP, and the third lower encapsulation inorganic pattern LIL3 may be formed. The process of forming the third light emitting element ED3, the capping pattern CP, and the third lower encapsulation inorganic pattern LIL3 may be substantially the same as the process of forming the first light emitting element ED1, the capping pattern CP, and the first lower encapsulation inorganic pattern LIL1, which is described through FIGS. 7E to 7G.

Thereafter, referring to FIG. 7J, the method of manufacturing a display panel according to the present disclosure may include an operation of forming the auxiliary electrode SE by removing the second partition wall layer L2 (see FIG. 7I) and the third partition wall layer L3 (see FIG. 7I).

The second partition wall layer L2 may be removed through wet etching, and the third partition wall layer L3 formed on the second partition wall layer L2 may be lifted off as the second partition wall layer L2 is removed. Through the above process, the second partition wall layer L2 and the third partition wall layer L3 may be removed, and the remaining first partition wall layer L1 may become the auxiliary electrode SE. That is, the first partition wall layer L1 and the auxiliary electrode SE may have the same configuration/structure.

The operation of forming the auxiliary electrode SE may include an operation of forming a gap area BA between the outer surfaces OS1, OS2, and OS3 of the plurality of lower encapsulation inorganic patterns LIL1, LIL2, and LIL3. The first to third lower encapsulation inorganic patterns LIL1, LIL2, and LIL3 may be provided in the form of patterns spaced apart from each other, and the outer surfaces OS1, OS2, and OS3 of the plurality of lower encapsulation inorganic patterns LIL1, LIL2, and LIL3 may define the gap area BA. For example, the gap areas BA may be defined between the outer surface OS1 of the first lower encapsulation inorganic pattern LIL1 and the outer surface OS2 of the second lower encapsulation inorganic pattern LIL2 and between the outer surface OS2 of the second lower encapsulation inorganic pattern LIL2 and the outer surface OS3 of the third lower encapsulation inorganic pattern LIL3.

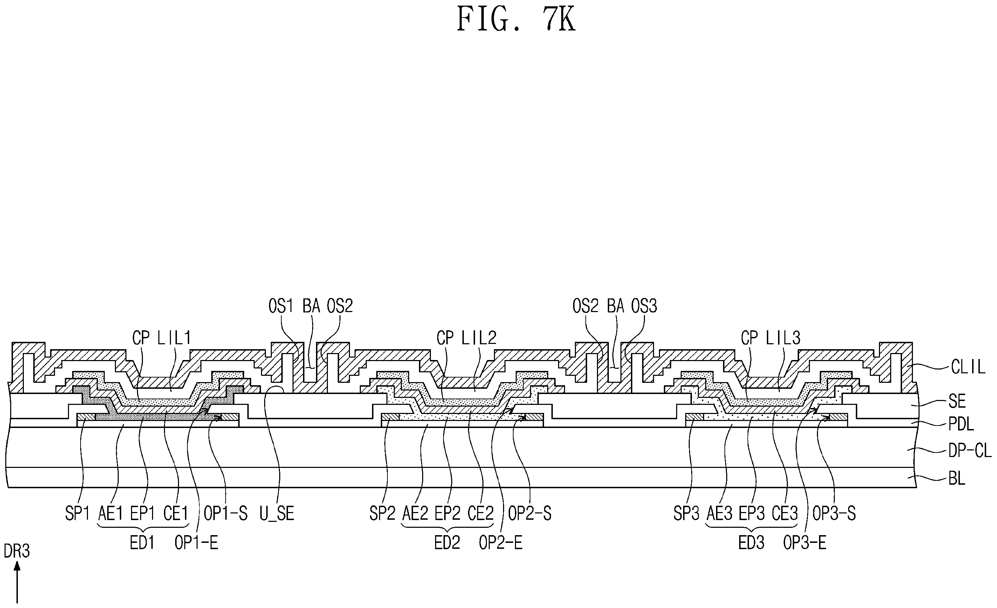

Referring to FIG. 7K, the method of manufacturing a display panel according to the present disclosure may include an operation of forming the common inorganic film CLIL having an integral shape while covering the outer surfaces OS1, OS2, and OS3 of the plurality of lower encapsulation inorganic patterns LIL1, LIL2, and LIL3. Alternatively, the method of manufacturing a display panel according to the present disclosure may include an operation of forming the common inorganic film CLIL that is in contact with the upper surface U_SE of the auxiliary electrode SE while covering the plurality of lower encapsulation inorganic patterns LIL1, LIL2, and LIL3.

The common inorganic film CLIL may cover the outer surfaces OS1, OS2, and OS3 of the plurality of lower encapsulation inorganic patterns LIL1, LIL2, and LIL3 and the upper surface U_SE of the auxiliary electrode SE. For example, the common inorganic film CLIL may cover the outer surface OS1 of the first lower encapsulation inorganic pattern LIL1, the upper surface U_SE of the auxiliary electrode SE, and the outer surface OS2 of the second lower encapsulation inorganic pattern LIL2 and may cover the outer surface OS2 of the second lower encapsulation inorganic pattern LIL2, the upper surface U_SE of the auxiliary electrode SE, and the outer surface OS3 of the third lower encapsulation inorganic pattern LIL3.

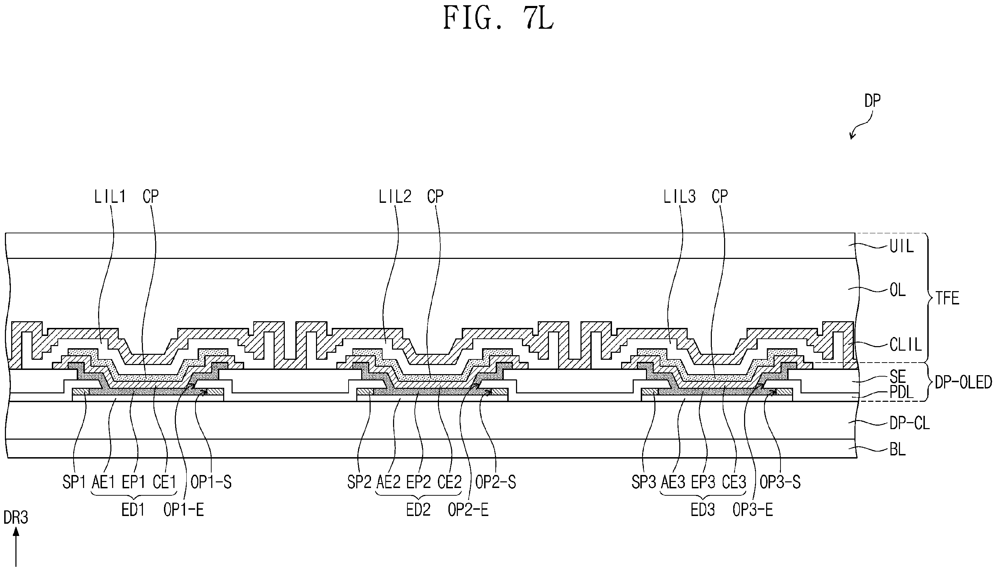

Thereafter, referring to FIG. 7L, the method of manufacturing a display panel according to the present disclosure may include an operation of completing the display panel DP by forming the encapsulation organic film OL and the upper encapsulation inorganic film UIL. The encapsulation organic film OL may be formed by applying an organic material in an inkjet method, but the present disclosure is not limited thereto. The encapsulation organic film OL provides a flattened upper surface in another embodiment. Thereafter, the upper encapsulation inorganic film UIL may be formed by depositing an inorganic material. Therefore, the display panel DP including the base layer BL, the circuit element layer DP-CL, the display element layer DP-OLED, and the thin film encapsulation layer TFE may be formed.

According to the above description, unlike a structure in which a cathode is in contact with a side surface of a partition wall containing aluminium (Al), as the cathode may be in direct contact with an auxiliary electrode containing titanium (Ti), contact defects caused by aluminium oxidation may be effectively reduced or eliminated, and as the cathode is in contact with an upper surface of the auxiliary electrode, a contact length may be increased. Further, the lower encapsulation inorganic pattern may be in direct contact with the upper surface of the auxiliary electrode while covering the cathode, thereby forming joining between an inorganic material and a metallic material. Thus, contact reliability of the cathode may be improved, and defects resulting from moisture penetration into the display panel may be effectively reduced or eliminated.

Unlike a structure in which patterning is performed using a partition wall and the partition wall remains finally, in an embodiment, the partition wall is removed after the patterning, and thus a display panel may have a structure that is robust to an external impact, and the partition wall positioned in a light emitting flow path is removed, and thus light emitting efficiency of the light emitting element may be effectively increased.

Although the description has been made above with reference to an embodiment of the present disclosure, it may be understood that those skilled in the art or those having ordinary knowledge in the art may variously modify and change the present disclosure without departing from the technical scope of the present disclosure described in the appended claims. Thus, the technical scope of the present disclosure is not limited to the detailed description of the specification but should be defined by the appended claims.

Embodiments are set out in the following clauses:
Clause 1. A display panel comprising:
   a base layer;
   a pixel defining film disposed on the base layer and having a light emitting opening;
   an auxiliary electrode disposed on the pixel defining film and including a conductive material;
   a light emitting element including an anode, a light emitting pattern disposed on the pixel defining film and the auxiliary electrode, and a cathode disposed on the auxiliary electrode and the light emitting pattern; and
   a lower encapsulation inorganic pattern configured to cover the light emitting element.
Clause 2. The display panel of clause 1, wherein a distal end of the cathode is in direct contact with an upper surface of the auxiliary electrode.
Clause 3. The display panel of clause 1 or clause 2, wherein the cathode is in direct contact with a side surface of the auxiliary electrode.
Clause 4. The display panel of any one of clauses 1 to 3, wherein the lower encapsulation inorganic pattern covers the cathode and is in direct contact with an upper surface of the auxiliary electrode.
Clause 5. The display panel of any one of clauses 1 to 4, wherein the auxiliary electrode has an auxiliary opening, and the auxiliary opening overlaps the light emitting opening.
Clause 6. The display panel of clause 5, wherein the light emitting pattern is disposed inside the light emitting opening and the auxiliary opening.
Clause 7. The display panel of any one of clauses 1 to 6, wherein the auxiliary electrode includes titanium (Ti).
Clause 8. The display panel of any one of clauses 1 to 7, wherein a distal end of the lower encapsulation inorganic pattern extends in a thickness direction of the base layer.
Clause 9. The display panel of any one of clauses 1 to 8, wherein the light emitting element and the lower encapsulation inorganic pattern are provided in plurality, and
   wherein a plurality of light emitting elements are spaced apart from each other, and lower encapsulation inorganic patterns are spaced apart from each other while covering the light emitting elements, respectively.
Clause 10. The display panel of clause 9, further comprising:
   a common inorganic film having an integral shape while covering the plurality of lower encapsulation inorganic patterns;
   an encapsulation organic film disposed on the common inorganic film; and an upper encapsulation inorganic film disposed on the encapsulation organic film.
Clause 11. The display panel of clause 10, wherein outer surfaces of the plurality of lower encapsulation inorganic patterns define a gap area, and wherein the common inorganic film covers the outer surfaces of the plurality of lower encapsulation inorganic patterns and an upper surface of the auxiliary electrode.
Clause 12. A display panel comprising:
   a base layer;
   a pixel defining film disposed on the base layer and having a first light emitting opening and a second light emitting opening;
   an auxiliary electrode disposed on the pixel defining film;
   a first light emitting element including a first anode, a first light emitting pattern, and
   a first cathode that are sequentially arranged in a thickness direction of the base layer;
   a second light emitting element including a second anode, a second light emitting pattern, and a second cathode that are sequentially arranged in the thickness direction of the base layer;
   a first lower encapsulation inorganic pattern disposed on the first light emitting element and the auxiliary electrode and configured to cover the first light emitting element;
   a second lower encapsulation inorganic pattern disposed on the second light emitting element and the auxiliary electrode, configured to cover the second light emitting element, and spaced apart from the first lower encapsulation inorganic pattern; and
   a common inorganic film configured to cover an upper surface and an outer surface of the first lower encapsulation inorganic pattern, an upper surface and an outer surface of the second lower encapsulation inorganic pattern, and an upper surface of the auxiliary electrode.
13. A method of manufacturing a display panel, the method comprising:
   providing a preliminary display panel including a base layer and a pixel defining film disposed on the base layer;
   forming a preliminary partition wall including a first preliminary partition wall layer, a second preliminary partition wall layer, and a third preliminary partition wall layer on the preliminary display panel;
   forming a partition wall having a plurality of partition wall openings and including a first partition wall layer, a second partition wall layer, and a third partition wall layer from the preliminary partition wall;
   forming a plurality of light emitting openings overlapping the plurality of partition wall openings by etching the pixel defining film;
   forming a plurality of light emitting elements on the pixel defining film and the first partition wall layer;
   forming a plurality of lower encapsulation inorganic patterns covering the plurality of light emitting elements on the light emitting element and the first partition wall layer; and
   forming an auxiliary electrode by removing the second preliminary partition wall layer and the third preliminary partition wall layer.
14. The method of clause 13, wherein the forming of the partition wall having the plurality of partition wall openings and including the first partition wall layer, the second partition wall layer, and the third partition wall layer from the preliminary partition wall includes:
   dry etching the first to third preliminary partition wall layers; and
   wet etching the second preliminary partition wall layer,
   wherein the second partition wall layer is recessed inward as compared to the first and third partition wall layers.
15. The method of clause 13 or clause 14, wherein the forming of the plurality of light emitting elements on the pixel defining film and the first partition wall layer includes:
   forming a light emitting pattern on the pixel defining film and the first partition wall layer; and
   forming a cathode on the light emitting pattern such that a distal end thereof is in contact with an upper surface of the first partition wall layer.
16. The method of clause 15, wherein the forming of the plurality of lower encapsulation inorganic patterns covering the plurality of light emitting elements on the light emitting element and the first partition wall layer includes:
   depositing a lower encapsulation inorganic layer such that the lower encapsulation inorganic layer covers the cathode and is in direct contact with the upper surface of the first partition wall layer.
17. The method of clause 15 or clause 16, wherein the forming of the plurality of lower encapsulation inorganic patterns covering the plurality of light emitting elements on the light emitting element and the first partition wall layer includes:
   depositing a lower encapsulation inorganic layer such that the lower encapsulation inorganic layer is in contact with the upper surface of the first partition wall layer and
   a side surface of the second partition wall layer.
18. The method of any one of clauses 13 to 17, wherein the forming of the auxiliary electrode by removing the second preliminary partition wall layer and the third preliminary partition wall layer includes:
   forming a gap area between outer surfaces of the plurality of lower encapsulation inorganic patterns.
19. The method of clause 18, further comprising:
   forming a common inorganic film having an integral shape while covering the outer surfaces of the plurality of lower encapsulation inorganic patterns.
20. The method of clause 18 or clause 19, further comprising:
   forming a common inorganic film in contact with an upper surface of the auxiliary electrode while covering the plurality of lower encapsulation inorganic patterns.
21. The method of any one of clauses 13 to 20, wherein the forming of the preliminary partition wall including the first preliminary partition wall layer, the second preliminary partition wall layer, and the third preliminary partition wall layer on the preliminary display panel includes:
   depositing the first preliminary partition wall layer containing titanium (Ti);
   depositing the second preliminary partition wall layer containing aluminum (Al); and
   depositing the third preliminary partition wall layer containing titanium (Ti).

## Claims

1. A display panel comprising:
a base layer;
a pixel defining film disposed on the base layer and defining a light emitting opening therein;
an auxiliary electrode disposed on the pixel defining film and including a conductive material;
a light emitting element including an anode, a light emitting pattern disposed on the pixel defining film and the auxiliary electrode, and a cathode disposed on the auxiliary electrode and the light emitting pattern; and
a lower encapsulation inorganic pattern configured to cover the light emitting element.

2. The display panel of claim 1, wherein a distal end of the cathode is in direct contact with an upper surface of the auxiliary electrode.

3. The display panel of claim 1 or claim 2, wherein the cathode is in direct contact with a side surface of the auxiliary electrode.

4. The display panel of any one of claims 1 to 3, wherein the lower encapsulation inorganic pattern covers the cathode and is in direct contact with an upper surface of the auxiliary electrode.

5. The display panel of any one of claims 1 to 4, wherein the auxiliary electrode defines an auxiliary opening therein, and the auxiliary opening overlaps the light emitting opening in a thickness direction of the base layer.

6. The display panel of claim 5, wherein the light emitting pattern is disposed inside the light emitting opening and the auxiliary opening.

7. The display panel of any one of claims 1 to 6, wherein the auxiliary electrode includes titanium (Ti).

8. The display panel of any one of claims 1 to 7, wherein a distal end of the lower encapsulation inorganic pattern extends in a thickness direction of the base layer.

9. The display panel of any one of claims 1 to 8, wherein the light emitting element and the lower encapsulation inorganic pattern are each provided in plurality, and
wherein the plurality of light emitting elements are spaced apart from each other, and the plurality of lower encapsulation inorganic patterns are spaced apart from each other while covering the light emitting elements, respectively.

10. The display panel of claim 9, further comprising:
a common inorganic film having an integral shape while covering the plurality of lower encapsulation inorganic patterns;
an encapsulation organic film disposed on the common inorganic film; and
an upper encapsulation inorganic film disposed on the encapsulation organic film.

11. The display panel of claim 10, wherein outer surfaces of the plurality of lower encapsulation inorganic patterns define a gap area, and
wherein the common inorganic film covers the outer surfaces of the plurality of lower encapsulation inorganic patterns and an upper surface of the auxiliary electrode.

12. A display panel according to claim 1, wherein:
the pixel defining film defines a first light emitting opening and a second light emitting opening therein;
the light emitting element includes a first light emitting element and a second light emitting element, wherein the first light emitting element includes a first anode, a first light emitting pattern, and a first cathode that are sequentially arranged in a thickness direction of the base layer, and the second light emitting element includes a second anode, a second light emitting pattern, and a second cathode that are sequentially arranged in the thickness direction of the base layer;
the lower encapsulation inorganic pattern comprises a first encapsulation inorganic pattern and a second encapsulation inorganic pattern, wherein the first encapsulation inorganic pattern is disposed on the first light emitting element and the auxiliary electrode and is configured to cover the first light emitting element, and the second encapsulation inorganic pattern is disposed on the second light emitting element and the auxiliary electrode, is configured to cover the second light emitting element, and is spaced apart from the first encapsulation inorganic pattern; and
the display panel further comprises a common inorganic film configured to cover an upper surface and an outer surface of the first encapsulation inorganic pattern, an upper surface and an outer surface of the second encapsulation inorganic pattern, and an upper surface of the auxiliary electrode.

13. A method of manufacturing a display panel, the method comprising:
providing a preliminary display panel including a base layer and a pixel defining film disposed on the base layer;
forming a preliminary partition wall including a first preliminary partition wall layer, a second preliminary partition wall layer, and a third preliminary partition wall layer and disposed on the preliminary display panel;
forming a partition wall defining a plurality of partition wall openings therein and including a first partition wall layer, a second partition wall layer, and a third partition wall layer from the preliminary partition wall;
forming a plurality of light emitting openings overlapping the plurality of partition wall openings by etching the pixel defining film;
forming a plurality of light emitting elements disposed on the pixel defining film and the first partition wall layer;
forming a plurality of encapsulation inorganic patterns covering the plurality of light emitting elements and disposed on the light emitting elements and the first partition wall layer; and
forming an auxiliary electrode by removing the second preliminary partition wall layer and the third preliminary partition wall layer.

14. The method of claim 13, wherein the forming of the auxiliary electrode includes:
forming a gap area between outer surfaces of the plurality of encapsulation inorganic patterns.

15. . The method of claim 13, wherein the forming of the preliminary partition wall includes:
depositing the first preliminary partition wall layer, which contains titanium (Ti);
depositing the second preliminary partition wall layer, which contains aluminum (Al); and
depositing the third preliminary partition wall layer, which contains titanium (Ti).
